(19)

Europäisches Patentamt
European Patent Office
Office européen des brevets

(11) **EP 4 246 622 A1**

(12) **EUROPEAN PATENT APPLICATION**
published in accordance with Art. 153(4) EPC

(43) Date of publication:
**20.09.2023 Bulletin 2023/38**

(21) Application number: **21892208.6**

(22) Date of filing: **01.11.2021**

(51) International Patent Classification (IPC):
$H01M\ 4/36^{(2006.01)}$    $H01M\ 4/38^{(2006.01)}$
$H01M\ 4/587^{(2010.01)}$    $H01M\ 4/62^{(2006.01)}$
$H01M\ 4/48^{(2010.01)}$    $H01M\ 10/052^{(2010.01)}$
$C01B\ 33/02^{(2006.01)}$    $C01B\ 33/10^{(2006.01)}$

(52) Cooperative Patent Classification (CPC):
C01B 33/02; C01B 33/10; C01B 33/22;
C23C 16/26; C23C 16/44; H01M 4/36; H01M 4/38;
H01M 4/48; H01M 4/587; H01M 4/62;
H01M 10/052; Y02E 60/10

(86) International application number:
**PCT/KR2021/015550**

(87) International publication number:
**WO 2022/103038 (19.05.2022 Gazette 2022/20)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **16.11.2020  KR 20200152973**

(71) Applicant: **Daejoo Electronic Materials Co., Ltd.
Siheung-si, Gyeonggi-do 15094 (KR)**

(72) Inventors:
• **LIM, Jong Chan
  Siheung-si, Gyeonggi-do 15094 (KR)**
• **LEE, Junghyun
  Siheung-si, Gyeonggi-do 15094 (KR)**

• **JEON, Young Min
  Siheung-si, Gyeonggi-do 15094 (KR)**
• **LIM, Sung Woo
  Siheung-si, Gyeonggi-do 15094 (KR)**
• **PARK, Jeong Gyu
  Siheung-si, Gyeonggi-do 15094 (KR)**
• **LEE, Hyun Seok
  Siheung-si, Gyeonggi-do 15094 (KR)**
• **LIM, Hyun Hee
  Siheung-si, Gyeonggi-do 15094 (KR)**
• **NAM, Sang Jin
  Siheung-si, Gyeonggi-do 15094 (KR)**
• **LEE, Eorang
  Siheung-si, Gyeonggi-do 15094 (KR)**

(74) Representative: **HGF
HGF Limited
1 City Walk
Leeds LS11 9DX (GB)**

(54) **POROUS SILICON-CARBON COMPOSITE, MANUFACTURING METHOD THEREFOR, AND NEGATIVE ELECTRODE ACTIVE MATERIAL COMPRISING SAME**

(57)    The present invention provides a porous silicon-carbon composite, a manufacturing method therefor, and a negative electrode active material comprising same. Since the porous silicon-carbon composite of the present invention includes silicon particles, magnesium fluoride, and carbon, the initial efficiency and capacity retention ratio of a secondary battery can be further increased as well as the discharge capacity thereof.

[Fig. 6c]

EP 4 246 622 A1

## Description

### Technical Field

The present invention relates to a porous silicon-carbon composite, to a process for preparing the same, and to a negative electrode active material comprising the same.

### Background Art

In recent years, as electronic devices become smaller, lighter, thinner, and more portable in tandem with the development of the information and communication industry, the demand for high energy density of batteries used as power sources for these electronic devices is increasing. A lithium secondary battery is a battery that can best meet this demand, and research on small batteries using the same, as well the application thereof to large electronic devices such as automobiles and power storage systems is being actively conducted.

Carbon materials are widely used as a negative electrode active material of such a lithium secondary battery. Silicon-based negative electrode active material is being studied in order to further enhance the capacity of a battery. Since the theoretical capacity of silicon (4,199 mAh/g) is greater than that of graphite (372 mAh/g) by 10 times or more, a significant enhancement in the battery capacity is expected.

The reaction scheme when lithium is intercalated into silicon is, for example, as follows:

$$[\text{Reaction Scheme 1}]$$

$$22Li + 5Si = Li_{22}Si_5$$

In a silicon-based negative electrode active material according to the above reaction scheme, an alloy containing up to 4.4 lithium atoms per silicon atom with a high capacity is formed. However, in most silicon-based negative electrode active materials, volume expansion of up to 300% is induced by the intercalation of lithium, which destroys the negative electrode, making it difficult to exhibit high cycle characteristics.

In addition, this volume change may cause cracks on the surface of the negative electrode active material, and an ionic material may be formed inside the negative electrode active material, thereby causing the negative electrode active material to be electrically detached from the current collector. This electrical detachment phenomenon may significantly reduce the capacity retention rate of a battery.

In order to solve this problem, Japanese Patent No. 4393610 discloses a negative electrode active material in which silicon and carbon are mechanically processed to form a composite, and the surface of the silicon particles is coated with a carbon layer using a chemical vapor deposition (CVD) method.

In addition, Japanese Laid-open Patent Publication No. 2016-502253 discloses a negative electrode active material comprising porous silicon-based particles and carbon particles, wherein the carbon particles comprise fine carbon particles and coarse-grained carbon particles having different average particle diameters.

However, although these prior art documents relate to a negative electrode active material comprising silicon and carbon, there is a limit to suppressing volume expansion and contraction during charging and discharging. Thus, there is still a demand for research to solve these problems.

[Prior art documents]

[Patent documents]

(Patent Document 1) Japanese Patent No. 4393610
(Patent Document 2) Japanese Laid-open Patent Publication No. 2016-502253
(Patent Document 3) Korean Laid-open Patent Publication No. 2018-0106485

### Detailed Description of the Invention

### Technical Problem

An object of the present invention is to provide a porous silicon-carbon composite with improved capacity retention rate as well as charge and discharge capacity and initial charge and discharge efficiency when applied to a negative electrode active material as it comprises silicon particles, fluorine-containing magnesium compound, and carbon.

Another object of the present invention is to provide a process for preparing the porous silicon-carbon composite.

Still another object of the present invention is to provide a negative electrode active material comprising the porous silicon-carbon composite and a lithium secondary battery comprising the same.

**Solution to the Problem**

The present invention provides a porous silicon-carbon composite comprising silicon particles, fluorine-containing magnesium compound, and carbon.

In addition, the present invention provides a process for preparing a porous silicon-carbon composite, which comprises a first step of obtaining a silicon composite oxide powder using a silicon-based raw material and a magnesium-based raw material; a second step of etching the silicon composite oxide powder using an etching solution comprising a fluorine (F) atom-containing compound; a third step of filtering and drying the composite obtained by the etching to obtain a porous silicon composite; and a fourth step of forming a carbon layer on the surface of the porous silicon composite by using a chemical thermal decomposition deposition method.

In addition, the present invention provides a negative electrode active material comprising the porous silicon-carbon composite.

Further, the present invention provides a lithium secondary battery comprising the negative electrode active material.

**Advantageous Effects of the Invention**

As the porous silicon-carbon composite according to an embodiment comprises silicon particles, fluorine-containing magnesium compound, and carbon, it is possible to enhance the discharge capacity as well as the initial efficiency and capacity retention rate when the porous silicon-carbon composite is applied to a negative electrode active material.

In addition, the process according to an embodiment has an advantage in that mass production is possible through a continuous process with minimized steps.

**Brief Description of the Drawing**

The following drawings attached to the present specification illustrate preferred embodiments of the present invention and serve to further understand the technical idea of the present invention together with the description of the present invention. Accordingly, the present invention should not be construed as being limited only to those depicted in the drawings.

Fig. 1a is a scanning electron microscope (SEM) photograph of the porous silicon composite (composite B1) prepared in Example 1. Fig. 1b is an ion beam scanning electron microscope (FIB-SEM) photograph of the porous silicon composite (composite B1) prepared in Example 1.

Figs. 2a to 2d are field emission scanning electron microscopy (FE-SEM) photographs of the surface of the porous silicon-carbon composite (composite C1) prepared in Example 1. They are shown in Figs. 2a to 2d according to the magnification, respectively.

Fig. 3 is an ion beam scanning electron microscope (FIB-SEM) photograph of the porous silicon-carbon composite (composite C1) prepared in Example 1.

Fig. 4 is an FIB-SEM EDAX photograph of the porous silicon-carbon composite (composite C1) prepared in Example 1 and a table of an analysis of the components in the composite.

Fig. 5 shows the results of a transmission electron microscope (TEM/EDS) analysis of the porous silicon-carbon composite (composite C1) prepared in Example 1.

Figs. 6a to 6c show the measurement results of an X-ray diffraction analysis of the silicon composite oxide (composite A1) (6a), the porous silicon composite (composite B1) (6b), and the porous silicon-carbon composite (composite C1) (6c) of Example 1.

Fig. 7 shows the measurement results of an X-ray diffraction analysis of the porous silicon-carbon composite (composite C2) of Example 2.

Fig. 8 shows the measurement results of an X-ray diffraction analysis of the porous silicon-carbon composite (composite C5) of Example 5.

Fig. 9 shows the measurement results of a Raman analysis of the porous silicon-carbon composite (composite C1) of Example 1.

**Best Mode for Carrying out the Invention**

The present invention is not limited to what is disclosed below. Rather, it may be modified in various forms as long as the gist of the invention is not altered.

In this specification, when a part is referred to as "comprising" an element, it is to be understood that the part may comprise other elements as well, unless otherwise indicated.

In addition, all numbers and expressions related to the quantities of components, reaction conditions, and the like used herein are to be understood as being modified by the term "about," unless otherwise indicated.

Hereinafter, the present invention will be described in detail.

[Porous silicon-carbon composite]

The porous silicon-carbon composite according to an embodiment of the present invention comprises silicon particles, fluorine-containing magnesium compound, and carbon.

As the porous silicon-carbon composite according to an embodiment comprises silicon particles, fluorine-containing magnesium compound, and carbon, it is possible to enhance the discharge capacity as well as the initial efficiency and capacity retention rate when the porous silicon-carbon composite is applied to a negative electrode active material.

Specifically, as the porous silicon-carbon composite according to an embodiment comprises silicon particles and fluorine-containing magnesium compound together, lithium does not react during charging in the fluorine-containing magnesium compound and lithium ions are not rapidly charged when lithium ions are charged and released in the silicon particles. Thus, it is possible to suppress volume expansion of the silicon particles when the secondary battery is charged, to impart excellent electrical conductivity since carbon is employed, and to suppress side reactions of the electrolyte. Accordingly, the porous silicon-carbon composite may further enhance the performance of the lithium secondary battery.

The porous silicon-carbon composite comprises a silicon composite and a carbon layer on its surface, the silicon particles and fluorine-containing magnesium compound are present in the silicon composite, and the carbon is present on a part or the entirety of the surfaces of the silicon particles and fluorine-containing magnesium compound to form a carbon layer.

In addition, since the porous silicon-carbon composite according to an embodiment of the present invention has a porous structure, an electrolyte can easily penetrate into the porous structure to enhance the output characteristics. Thus, the porous silicon-carbon composite can be advantageously used in the preparation of a negative electrode active material for a lithium secondary battery and a lithium secondary battery comprising the same.

Hereinafter, each component of the porous silicon-carbon composite will be described in detail.

**Silicon particles**

The porous silicon-carbon composite according to an embodiment of the present invention comprises silicon particles.

Since the silicon particles charge lithium, the capacity of a secondary battery may decrease if silicon particles are not employed. The silicon particles may be crystalline or amorphous and specifically may be amorphous or in a similar phase thereto. If the silicon particles are crystalline, a dense composite may be obtained as the size of the crystallites is small, which fortifies the strength of the matrix to prevent cracks. Thus, the initial efficiency or cycle lifespan characteristics of the secondary battery can be further enhanced. In addition, if the silicon particles are amorphous or in a similar phase thereto, expansion or contraction during charging and discharging of the lithium secondary battery is small, and battery performance such as capacity characteristics can be further enhanced.

Although the silicon particles have high initial efficiency and battery capacity, it is accompanied by a very complex crystal change by electrochemically absorbing, storing, and releasing lithium atoms. The silicon particles may be uniformly distributed inside the porous silicon-carbon composite. In such a case, excellent mechanical properties such as strength may be achieved.

In addition, the porous silicon-carbon composite may have a structure in which silicon particles and fluorine-containing magnesium compound are uniformly dispersed. In addition, the fluorine-containing magnesium compound may be dispersed together with the silicon particles to surround them, thereby suppressing the expansion and contraction of silicon to obtain high performance of the secondary battery.

The silicon particles contained in the porous silicon-carbon composite according to an embodiment of the present invention may be in an amorphous form, a crystalline form having a crystallite size of 2 nm to 20 nm, or a mixture thereof.

Specifically, in the porous silicon-carbon composite, when the silicon particles are subjected to an X-ray diffraction (Cu-K$\alpha$) analysis using copper as a cathode target and calculated by the Scherrer equation based on a full width at half maximum (FWHM) of the diffraction peak of Si (220) around $2\theta = 47.5°$, they may have a crystallite size of 2 nm to 20 nm, 2 nm to 15 nm, or 2 nm to 10 nm.

If the silicon particles comprise a crystalline form, and if the crystallite size of the silicon particles is less than 2 nm, it is not easy to prepare them, and the yield after etching may be low. In addition, if the crystallite size exceeds 20 nm, the micropores cannot adequately suppress the volume expansion of silicon particles that occur during charging and discharging, a region that does not contribute to discharging is present, and a reduction in the Coulombic efficiency representing the ratio of charge capacity to discharge capacity cannot be suppressed.

In the porous silicon-carbon composite, the content of silicon (Si) may be 8% by weight to 95% by weight, 20% by weight to 80% by weight, or 30% by weight to 70% by weight, based on the total weight of the porous silicon-carbon composite.

If the content of silicon (Si) is less than 8% by weight, the amount of an active material for occlusion and release of lithium is small, which may reduce the charge and discharge capacity of the lithium secondary battery. On the other hand, if it exceeds 95% by weight, the charging and discharge capacity of the lithium secondary battery may be increased, whereas the expansion and contraction of the electrode during charging and discharging may be excessively increased, and the negative electrode active material powder may be further atomized, which may deteriorate the cycle characteristics.

**Fluorine-containing magnesium compound**

The porous silicon-carbon composite according to an embodiment of the present invention comprises fluorine-containing magnesium compound.

The preferable characteristics of the porous silicon-carbon composite that comprises fluorine-containing magnesium compound according to an embodiment of the present invention will be described below.

In general, silicon particles may occlude lithium ions during the charging of the secondary battery to form an alloy, which may increase the lattice constant and thereby expand the volume. In addition, during discharging of the secondary battery, lithium ions are released to return to the original metal nanoparticles, thereby reducing the lattice constant.

The fluorine-containing magnesium compound may be considered as a zero-strain material that does not accompany a change in the crystal lattice constant while lithium ions are occluded and released. The silicon particles may be present between the fluorine-containing magnesium compound particles and may be surrounded by the fluorine-containing magnesium compound particles.

Meanwhile, the fluorine-containing magnesium compound does not release lithium ions during the charging of the lithium secondary battery. For example, it is also an inactive material that does not occlude or release lithium ions during the charging of the lithium secondary battery

That is, in the porous silicon-carbon composite, lithium ions are released from the silicon particles, whereas lithium ions, which have been steeply increased during charging, are not released from the fluorine-containing magnesium compound. Thus, the porous matrix comprising fluorine-containing magnesium compound does not participate in the chemical reaction of the battery, but it is expected to function as a body that suppresses the volume expansion of silicon particles during the charging of the secondary battery.

The content of the fluorine-containing magnesium compound may be 0.04 to 56.3% by weight, 0.5 to 25% by weight, or 1 to 19% by weight, based on the total weight of the porous silicon-carbon composite. If the content of the fluorine-containing magnesium compound satisfies the above range, the cycle characteristics and capacity characteristics of the secondary battery may be further enhanced.

The fluorine-containing magnesium compound may comprise magnesium fluoride ($MgF_2$), magnesium fluoride silicate ($MgSiF_6$), or a mixture thereof, and it may have a crystalline structure. For example, when the fluorine-containing magnesium compound is subjected to an X-ray diffraction (Cu-K$\alpha$) analysis using copper as a cathode target and calculated by the Scherrer equation based on a full width at half maximum (FWHM) of the diffraction peak of $MgF_2$ (111) around $2\theta = 40°$, $MgF_2$ may have a crystallite size of 2 nm to 35 nm, 5 nm to 25 nm, or 5 nm to 15 nm. If the crystallite size of $MgF_2$ is within the above range, it may function as a body for suppressing the volume expansion of silicon particles during charging and discharging of the lithium secondary battery.

According to an embodiment of the present invention, in an X-ray diffraction (Cu-K$\alpha$) analysis using copper as a cathode target, an IB/IA as a ratio of the diffraction peak intensity (IB) for an $MgF_2$ (111) crystal plane around $2\theta = 40.4°$ to the diffraction peak intensity (IA) for an Si (220) crystal plane around $2\theta = 47.3°$ may be greater than 0 to 1. If the IB/IA exceeds 1, there may be a problem in that the capacity of the secondary battery is deteriorated.

The content of magnesium (Mg) in the porous silicon-carbon composite may be 0.5% by weight to 20% by weight, 0.5% by weight to 15% by weight, or 0.5% by weight to 8% by weight, based on the total weight of the porous silicon-carbon composite. If the content of magnesium (Mg) in the porous silicon-carbon composite is less than 0.5% by weight, there may be a problem in that the cycle characteristics of the secondary battery are reduced. If it exceeds 20% by weight, there may be a problem in that the charge capacity of the secondary battery is reduced.

Meanwhile, according to an embodiment of the present invention, the porous silicon-carbon composite may comprise a fluoride and/or silicate containing a metal other than magnesium. The other metal may be at least one selected from the group consisting of alkali metals, alkaline earth metals, Groups 13 to 16 elements, transition metals, rare earth elements, and combinations thereof. Specific examples thereof may include Li, Ca, Sr, Ba, Y, Ti, Zr, Hf, V, Nb, Cr, Mo, W, Fe, Pb, Ru, Ir, Pd, Pt, Cu, Ag, Au, Zn, Cd, B, Al, Ga, Sn, In, Ti, Ge, P, As, Sb, Bi, S, and Se.

**Magnesium silicate**

The porous silicon-carbon composite may further comprise magnesium silicate.

The magnesium silicate may comprise $MgSiO_3$ crystals, $Mg_2SiO_4$ crystals, or a mixture thereof.

In particular, as the porous silicon-carbon composite comprises $MgSiO_3$ crystals, the Coulombic efficiency or capacity retention rate may be increased.

The content of the magnesium silicate may be 0 to 30% by weight, 0.5 to 25% by weight, or 0.5 to 20% by weight, based on the total weight of the porous silicon-carbon composite.

According to an embodiment of the present invention, in the porous silicon-carbon composite, magnesium silicate may be converted to fluorine-containing magnesium compound by etching.

For example, some, most, or all of the magnesium silicate may be converted to fluorine-containing magnesium compound depending on the etching method or etching degree. More specifically, most of the magnesium silicate may be converted to fluorine-containing magnesium compound.

**Silicon oxide compound**

The porous silicon-carbon composite may further comprise a silicon oxide compound.

The silicon oxide compound may be a silicon-based oxide represented by the formula $SiO_x$ ($0.5 \leq x \leq 2$). The silicon oxide compound may be specifically $SiO_x$ ($0.8 < x \leq 1.2$), more specifically $SiO_x$ ($0.9 < x \leq 1.1$). In the formula $SiO_x$, if the value of x is less than 0.5, expansion and contraction may be increased and lifespan characteristics may be deteriorated during charging and discharging of the secondary battery. In addition, if x exceeds 1.5, there may be a problem in that the initial efficiency of the secondary battery is decreased as the amount of inactive oxides increases.

The silicon oxide compound may be employed in an amount of 0.1% by weight to 45% by weight, preferably, 0.1% by weight to 35% by weight, more preferably, 0.1% by weight to 20% by weight, based on the total weight of the porous silicon-carbon composite.

If the content of the silicon oxide compound is less than 0.1% by weight, the volume of the secondary battery may expand, and the lifespan characteristics thereof may be deteriorated. On the other hand, if the content of the silicon oxide compound exceeds 45% by weight, the initial irreversible reaction of the secondary battery may be increased, thereby deteriorating the initial efficiency.

**Pores**

In the porous silicon-carbon composite according to an embodiment of the present invention, the pores formed therein have the volume expansion that takes place during charging and discharging concentrated on the pores rather than the outside of the negative electrode active material, thereby effectively controlling the volume expansion and enhancing the lifespan characteristics of the lithium secondary battery. In addition, the electrolyte can easily penetrate into the porous structure to enhance the output characteristics, so that the performance of the lithium secondary battery can be further enhanced.

In the present specification, pores may be used interchangeably with voids. In addition, the pores may comprise open pores, closed pores, or both. The closed pores refer to independent pores that are not connected to other pores because all of the walls of the pores are formed in a closed structure. In addition, the open pores are formed in an open structure in which at least a part of the walls of the pores are open, so that they may be, or may not be, connected to other pores. In addition, they may refer to pores exposed to the outside as they are disposed on the surface of the silicon composite before the coating of carbon (before the formation of a carbon layer).

The porosity of the pores in the porous silicon-carbon composite may be 0.1% by volume to 40% by volume, 10% by volume to 35% by volume, or 15% by volume to 30% by volume, based on the volume of the porous silicon-carbon composite. The porosity may be a porosity of the closed pores in the porous silicon-carbon composite.

If the porosity of the porous silicon-carbon composite satisfies the above range, it is possible to obtain a buffering effect of volume expansion while maintaining sufficient mechanical strength when applied to the negative electrode active material of a secondary battery. Thus, it is possible to minimize the problem of volume expansion due to the use of silicon particles, to achieve high capacity, and to enhance the lifespan characteristics. If the porosity of the porous silicon-carbon composite is less than 0.1% by volume, it may be difficult to control the volume expansion of the negative electrode active material during charging and discharging. If it exceeds 40% by volume, the mechanical strength is reduced due to a large number of pores present in the negative electrode active material, and there is a concern that the negative electrode active material may be collapsed in the process of manufacturing a secondary battery, for example, during the mixing of the negative electrode active material slurry and the rolling step after coating.

The porous silicon-carbon composite may comprise a plurality of pores, and the diameters of the pores may be the same as, or different from, each other.

**Carbon**

The porous silicon-carbon composite according to an embodiment of the present invention comprises carbon.

According to an embodiment of the present invention, as the porous silicon-carbon composite comprises carbon, it is possible to secure adequate electrical conductivity of the porous silicon-carbon composite and to adjust the specific surface area appropriately. Thus, when used as a negative electrode active material of a secondary battery, the lifespan characteristics and capacity of the secondary battery can be enhanced.

In general, the electrical conductivity of a negative electrode active material is an important factor for facilitating electron transfer during an electrochemical reaction. If the composite as a negative electrode active material does not comprise carbon, for example, when a high-capacity negative electrode active material is prepared using silicon particles and fluorine-containing magnesium compound, the electrical conductivity may not reach an appropriate level.

The present inventors have formed a carbon layer on the surface of a silicon composite composed of silicon particles and fluorine-containing magnesium compound, whereby it is possible to improve the charge and discharge capacity, initial charge efficiency, and capacity retention rate, to enhance the mechanical properties, to impart excellent electrical conductivity even after charging and discharging have been carried out and the electrode has been expanded, to suppress the side reaction of the electrolyte, and to further enhance the performance of the lithium secondary battery.

The porous silicon-carbon composite comprises a carbon layer on the surface of the silicon composite, and the carbon is present on a part or the entirety of the surfaces of the silicon particles and fluorine-containing magnesium compound to form a carbon layer. As the porous silicon-carbon composite comprises a carbon layer, it is possible to solve the difficulty of electrical contact between particles due to the presence of pores and to provide excellent electrical conductivity even after the electrode has been expanded during charging and discharging, so that the performance of the secondary battery can be further enhanced.

In addition, according to an embodiment of the present invention, the thickness of the carbon layer or the amount of carbon may be controlled, so that it is possible to achieve appropriate electrical conductivity, as well as to prevent a deterioration of the lifespan characteristics, to thereby achieve a high-capacity negative electrode active material.

The porous silicon-carbon composite on which a carbon layer is formed may have an average particle diameter ($D_{50}$) of 1 $\mu$m to 20 $\mu$m. In addition, the average particle diameter is a value measured as a volume average value $D_{50}$, i.e., a particle diameter or median diameter when the cumulative volume is 50% in particle size distribution measurement according to a laser beam diffraction method. Specifically, the average particle diameter ($D_{50}$) of the porous silicon-carbon composite may be 1 $\mu$m to 20 $\mu$m, 3 $\mu$m to 10 $\mu$m, or 3 $\mu$m to 8 $\mu$m. If the average particle diameter of the porous silicon-carbon composite is less than 1 $\mu$m, there is a concern that the dispersibility may be deteriorated due to the aggregation of particles of the composite during the preparation of a negative electrode slurry (i.e., a negative electrode active material composition) using the same. In addition, if the average particle diameter of the porous silicon-carbon composite exceeds 20 $\mu$m, the expansion of the composite particles due to charging of lithium ions becomes severe, and the binding capability between the particles of the composite and the binding capability between the particles and the current collector are deteriorated as charging and discharging are repeated, so that the lifespan characteristics may be significantly reduced. In addition, there is a concern that the activity may be deteriorated due to a decrease in the specific surface area.

According to an embodiment, the content of carbon (C) may be 3% by weight to 80% by weight, 3% by weight to 50% by weight, or 10% by weight to 30% by weight, based on the total weight of the porous silicon-carbon composite.

If the content of carbon (C) is less than 3% by weight, a sufficient effect of enhancing conductivity cannot be expected, and there is a concern that the electrode lifespan of the lithium secondary battery may be deteriorated. In addition, if it exceeds 80% by weight, the discharge capacity of the secondary battery may decrease and the bulk density may decrease, so that the charge and discharge capacity per unit volume may be deteriorated.

The carbon layer may have an average thickness of 1 nm to 300 nm or 3 nm to 150 nm, more specifically, 5 nm to 100 nm. If the thickness of the carbon layer is 1 nm or more, an enhancement in conductivity may be achieved. If it is 300 nm or less, a decrease in capacity of the secondary battery may be suppressed.

The average thickness of the carbon layer may be measured, for example, by the following procedure.

First, the negative electrode active material is observed at an arbitrary magnification by a transmission electron microscope (TEM). The magnification is preferably, for example, a degree that can be confirmed with the naked eyes. Subsequently, the thickness of the carbon layer is measured at arbitrary 15 points. In such an event, it is preferable to select the measurement positions at random widely as much as possible, without concentrating on a specific region. Finally, the average value of the thicknesses of the carbon layer at the 15 points is calculated.

The carbon layer may comprise at least one selected from the group consisting of graphene, reduced graphene oxide, a carbon nanotube, a carbon nanofiber, and graphite. For example, the carbon layer may comprise at least one selected from graphene, reduced graphene oxide, a carbon nanotube, and a carbon nanofiber. Specifically, it may comprise graphene. In addition, the carbon layer may further comprise graphite.

In addition, the porous silicon-carbon composite according to an embodiment of the present invention may be formed by thermally treating the porous silicon composite with a gas or vapor of a carbon source at a high temperature, and it may comprise pores therein. In addition, the pores may be present on the surface, inside, or both of the silicon composite. The surface of the silicon composite may refer to the outermost portion of the silicon composite. The inside of the silicon composite may refer to a portion other than the outermost portion, that is, an inner portion of the outermost portion.

In addition, the porous silicon-carbon composite is a composite in which a plurality of silicon particles are uniformly distributed in a composite whose structure is in the form of a single mass, for example, a polyhedral, spherical, or similar shape. It may be in a single structure in which carbon, more specifically, a carbon layer comprising carbon surrounds a part or all of the surfaces of one or more silicon particles (primary silicon particles) or the surfaces of secondary silicon particles (clumps) formed by the aggregation of two or more silicon particles.

The porous silicon-carbon composite may have a specific surface area (Brunauer-Emmett-Teller method; BET) of 2 m$^2$/g to 60 m$^2$/g, 3 m$^2$/g to 50 m$^2$/g, or 3 m$^2$/g to 40 m$^2$/g. If the specific surface area of the porous silicon-carbon composite is less than 2 m$^2$/g, the rate characteristics of the secondary battery may be deteriorated. If it exceeds 60 m$^2$/g, it may be difficult to prepare a negative electrode slurry suitable for application to a negative electrode current collector of the secondary battery, the contact area with an electrolyte increases, and the decomposition reaction of the electrolyte may be accelerated or a side reaction of the secondary battery may be caused.

The porous silicon-carbon composite may have a specific gravity of 1.8 g/cm$^3$ to 2.6 g/cm$^3$, specifically, 1.8 g/cm$^3$ to 2.5 g/cm$^3$, more specifically, 2.0 g/cm$^3$ to 2.5 g/cm$^3$. The specific gravity may vary depending on the coating amount of a carbon layer. While the amount of carbon is fixed, the greater the specific gravity within the above range, the fewer pores in the composite. Therefore, when used as a negative electrode active material, the conductivity is enhanced, and the strength of the matrix is fortified, thereby enhancing the initial efficiency and cycle lifespan characteristics. In such an event, specific gravity may refer to true specific gravity, density, or true density. According to an embodiment of the present invention, for the measurement of specific gravity, for example, the measurement of specific gravity by a dry density meter, Acupick II 1340 manufactured by Shimadzu Corporation may be used as a dry density meter. The purge gas to be used may be helium gas, and the measurement may be carried out after 200 times of purge in a sample holder set at a temperature of 23°C.

If the specific gravity of the porous silicon-carbon composite is 1.8 g/cm$^3$ or more, the dissociation between the negative electrode active material powder due to volume expansion of the negative electrode active material powder during charging may be prevented, and the cycle deterioration may be suppressed. If the specific gravity is 2.6 g/cm$^3$ or less, the impregnability of an electrolyte is enhanced, which increases the utilization rate of the negative electrode active material, so that the initial charge and discharge capacity can be enhanced.

**[Process for preparing a porous silicon-carbon composite]**

The process for preparing a porous silicon-carbon composite according to an embodiment of the present invention comprises a first step of obtaining a silicon composite oxide powder using a silicon-based raw material and a magnesium-based raw material; a second step of etching the silicon composite oxide powder using an etching solution comprising a fluorine (F) atom-containing compound; a third step of filtering and drying the composite obtained by the etching to obtain a porous silicon composite; and a fourth step of forming a carbon layer on the surface of the porous silicon composite by using a chemical thermal decomposition deposition method.

The process according to an embodiment has an advantage in that mass production is possible through a continuous process with minimized steps.

Specifically, in the process for preparing a porous silicon-carbon composite, the first step may comprise obtaining a silicon composite oxide powder using a silicon-based raw material and a magnesium-based raw material.

The silicon-based raw material may comprise at least one selected from the group consisting of a silicon powder, a silicon oxide powder, and a silicon dioxide powder.

The magnesium-based raw material may comprise metallic magnesium.

The first step may be carried out by, for example, using the method described in Korean Laid-open Patent Publication No. 10-2018-0106485.

The content of magnesium (Mg) in the silicon composite oxide powder may be 0.5% by weight to 20% by weight, 0.5% by weight to 15% by weight, or 0.5% by weight to 8% by weight, based on the total weight of the silicon composite oxide. If the content of magnesium (Mg) in the silicon composite oxide is less than 0.5% by weight, there may be a problem in that the cycle characteristics of the secondary battery are deteriorated. If it exceeds 20% by weight, there may be a problem in that the charge capacity of the secondary battery is deteriorated.

The silicon composite oxide may have a specific surface area (Brunauer-Emmett-Teller method; BET) of 2 $m^2/g$ to 100 $m^2/g$, 3 $m^2/g$ to 80 $m^2/g$, or 3 $m^2/g$ to 50 $m^2/g$. If the specific surface area of the silicon composite oxide is less than 2 $m^2/g$, the average particle diameter of the particles is too large. Thus, when applied to a current collector as a negative electrode active material of a secondary battery, an uneven electrode may be formed, which impairs the lifespan of the secondary battery. If it exceeds 100 $m^2/g$, it is difficult to control the heat generated by the etching reaction in the second step, and the yield of the composite after etching may be reduced.

According to an embodiment of the present invention, the process may further comprise forming a carbon layer on the surface of the silicon composite oxide by using a chemical thermal decomposition deposition method.

Specifically, once a carbon layer has been formed on the surface of the silicon composite oxide powder comprising the silicon particles and fluorine-containing magnesium compound, the etching process of the second step may be carried out. In such a case, there may be an advantage in that uniform etching is possible and a high yield may be obtained.

The step of forming a carbon layer may be carried out by a process similar or identical to the process of forming a carbon layer in the fourth step to be described below.

In the process for preparing a porous silicon-carbon composite, the second step may comprise etching the silicon composite oxide powder using an etching solution comprising a fluorine (F) atom-containing compound.

The etching step may comprise dry etching and wet etching.

If the dry etching is used, selective etching may be possible.

Silicon dioxide of the silicon composite oxide powder is dissolved and eluted by the etching step to thereby form pores.

The magnesium silicate is converted to fluorine-containing magnesium compound by the etching step, so that a porous silicon composite comprising silicon particles and fluorine-containing magnesium compound may be prepared.

The silicon composite oxide powder is etched using an etching solution comprising a fluorine (F) atom-containing compound in the etching step to thereby form pores.

The silicon composite oxide powder is etched using a fluorine (F) atom-containing compound (e.g., HF) to convert magnesium silicate to fluorine-containing magnesium compound, and pores are formed at the same time in the portion from which silicon dioxide has been eluted and removed. As a result, a porous silicon composite comprising silicon particles and fluorine-containing magnesium compound may be prepared.

For example, in the etching step in which HF is used, when dry etching is carried out, it may be represented by the following Reaction Schemes G1 and G2, and when wet etching is carried out, it may be represented by the following Reaction Schemes L1a to L2:

$$MgSi_3 + 6HF \text{ (gas)} \rightarrow SiF_4 \text{ (g)} + MgF_2 + 3H_2O \qquad \text{(G1)}$$

$$Mg_2SiO_4 + 8HF \text{ (gas)} \rightarrow SiF_4 \text{ (g)} + 2MgF_2 + 4H_2O \qquad \text{(G2)}$$

$$MgSiO_3 + 6HF \text{ (aq. solution)} \rightarrow MgSiF_6 + 3H_2O \qquad \text{(L1a)}$$

$$MgSiF_6 + 2HF \text{ (aq. solution)} \rightarrow MgF_2 + H_2SiF_6 \qquad \text{(L1b)}$$

$$MgSiO_3 + 2HF \rightarrow SiO_2 + MgF_2 + H_2O \qquad \text{(L1c)}$$

$$SiO_2 + 6HF \text{ (1)} \rightarrow H_2SiF_6 + 2H_2O \qquad \text{(L1d)}$$

$$MgSiO_3 + 8HF \text{ (aq. solution)} \rightarrow MgF_2 + H_2SiF_6 + 3H_2O \qquad \text{(L1)}$$

$$Mg_2SiO_4 + 8HF \text{ (aq. solution)} \rightarrow MgSiF_6 + MgF_2 + 4H_2O \qquad \text{(L2a)}$$

$$MgSiF_6 + 2HF \text{ (aq. solution)} \rightarrow MgF_2 + H_2SiF_6 \qquad \text{(L2b)}$$

$$Mg_2SiO_4 + 4HF \text{ (aq. solution)} \rightarrow SiO_2 + 2MgF_2 + 2H_2O \qquad \text{(L2c)}$$

$$SiO_2 + 6HF \text{ (aq. solution)} \rightarrow H_2SiF_6 + 2H_2O \qquad (L2d)$$

$$Mg_2SiO_4 + 10HF \text{ (aq. solution)} \rightarrow 2MgF_2 + H_2SiF_6 + 4H_2O \qquad (L2)$$

In addition, pores may be considered to be formed by the following Reaction Schemes (3) and (4).

$$SiO_2 + 4HF \text{ (gas)} \rightarrow SiF_4 + 2H_2O \qquad (3)$$

$$SiO_2 + 6HF \text{ (aq. solution)} \rightarrow H_2SiF_6 + 2H_2O \qquad (4)$$

Pores (voids) may be formed where silicon dioxide is dissolved and removed in the form of $SiF_4$ and $H_2SiF_6$ by the reaction mechanism as in the above reaction schemes.

In addition, silicon dioxide contained in the porous silicon composite may be removed depending on the degree of etching, and pores may be formed therein.

The degree of formation of pores may vary with the degree of etching. For example, pores may be hardly formed, or pores may be partially formed, specifically, pores may be formed only in the outer portion.

In addition, the ratio of O/Si and specific surface area of the porous silicon composite upon etching may significantly vary, respectively. In addition, the specific surface area and specific gravity in the silicon composite in which pores are formed may significantly vary before and after the coating of carbon.

According to an embodiment of the present invention, after the etching, crystals of both fluorine-containing magnesium compound and magnesium silicate may be contained.

Meanwhile, the composite upon etching may comprise porous silicon particles, magnesium fluoride, and magnesium silicate. In addition, the composite upon etching may comprise porous silicon particles and fluorine-containing magnesium compound even when a pattern of magnesium silicate is hardly detected in an X-ray diffraction analysis.

It is possible to obtain a porous silicon composite powder having a plurality of pores formed on the surface of the composite particles, or on the surface and inside thereof, through the etching. In addition, closed pores may be formed inside the porous silicon composite.

In addition, according to an embodiment, after the etching, crystals of both fluorine-containing magnesium compound and magnesium silicate may be contained. Here, etching refers to a process in which the silicon composite oxide powder is treated with an acidic aqueous solution containing an acid, for example, an etching solution containing a fluorine (F) atom-containing compound in the solution. The method of treatment with an etching solution may be a method in which the silicon composite oxide powder is added to an etching solution and stirred. In addition, the silicon composite oxide may be dispersed in a dispersion medium, and an etching solution may then be added thereto to carry out etching. The dispersion medium may comprise at least one selected from the group consisting of water, alcohol-based compounds, ketone-based compounds, ether-based compounds, hydrocarbon-based compounds, and fatty acids.

The stirring temperature (treatment temperature) is not particularly limited.

A commonly used etching solution may be used without limitation within a range that does not impair the effects of the present invention as the etching solution containing a fluorine (F) atom-containing compound.

Specifically, the fluorine (F) atom-containing compound may comprise at least one selected from the group consisting of HF, $NH_4F$, $NH_4$, and $HF_2$. As the fluorine (F) atom-containing compound is used, the porous silicon-carbon composite may comprise fluorine-containing magnesium compound, and the etching step may be carried out more quickly.

In addition, the etching solution may further comprise one or more acids selected from the group consisting of organic acids, sulfuric acid, hydrochloric acid, phosphoric acid, nitric acid, and chromic acid.

In the silicon composite oxide powder, a part of silicon oxide may remain in addition to silicon dioxide, and the portion from which silicon-containing oxide such as silicon dioxide or silicon oxide is removed by the etching may form voids or pores inside the particles. In addition, most of the magnesium silicate reacts with fluorine (F) in the fluorine (F) atom-containing compound in the etching solution through the etching to form fluorine-containing magnesium compound.

The composite obtained upon the etching is porous and may comprise silicon particles and fluorine-containing magnesium compound.

It is possible to obtain a porous composite having a plurality of pores formed on the surface, inside, or both of the composite particles through the etching. In addition, the number of oxygen present on the surface of the composite may be lowered by the etching. That is, it is possible to significantly lower the oxygen fraction on the surface of the composite and to reduce the surface resistance through the etching. As a result, when the composite is applied to a negative electrode active material, the electrochemical properties, particularly, lifespan characteristics of the lithium secondary battery can be remarkably improved.

In addition, as the selective etching removes a large amount of silicon dioxide, the silicon composite oxide may comprise silicon (Si) in a very high fraction as compared with oxygen (O). That is, the molar ratio (O/Si) of oxygen (O) atoms to silicon (Si) atoms present in the porous composite may be significantly reduced. In such a case, a secondary battery having a high capacity and excellent cycle characteristics as well as an improved first charge and discharge efficiency can be obtained.

In addition, pores or voids can be formed at positions where silicon dioxide is removed. As a result, the specific surface area of the silicon composite may be increased as compared with the specific surface area of the silicon composite oxide before etching.

The molar ratio (O/Si) of oxygen (O) atoms to silicon (Si) atoms present in the porous composite may be 0.01 to 1, 0.03 to 0.7, or 0.03 to 0.6. If the ratio is outside the above range, it acts as a resistance during the intercalation reaction of lithium, so that the electrochemical characteristics of the secondary battery may be deteriorated. As a result, the electrochemical characteristics, particularly, lifespan characteristics of the lithium secondary battery may be deteriorated.

In the porous silicon composite (a precursor before carbon coating) obtained upon the etching, the content of silicon (Si) may be 30% by weight to 99% by weight, 30% by weight to 80% by weight, or 30% by weight to 70% by weight, based on the total weight of the porous silicon composite.

If the content of silicon (Si) is less than 30% by weight, the amount of an active material for occlusion and release of lithium is small, which may reduce the charge and discharge capacity of the lithium secondary battery. On the other hand, if it exceeds 99% by weight, the charging and discharge capacity of the lithium secondary battery may be increased, whereas the expansion and contraction of the electrode during charging and discharging may be excessively increased, and the negative electrode active material powder may be further atomized, which may deteriorate the cycle characteristics.

The content of magnesium (Mg) in the porous silicon composite may be 0.5% by weight to 20% by weight, 0.5% by weight to 10% by weight, or 0.5% by weight to 6% by weight, based on the total weight of the porous silicon composite. If the content of magnesium (Mg) in the porous silicon composite is less than 0.5% by weight, there may be a problem in that the cycle characteristics of the secondary battery are deteriorated. If it exceeds 20% by weight, there may be a problem in that the charge capacity of the secondary battery is reduced.

According to an embodiment of the present invention, physical properties such as element content and specific surface area may vary before and after the etching step. That is, physical properties such as element content and specific surface area in the silicon composite oxide before the etching step and the silicon composite after the etching step may vary.

In addition, the silicon composite may be formed from a silicon composite oxide ($Mg_xSiO_y$, $0 < x \leq 0.2$, $0.8 < y < 1.2$). It is a composite in which a plurality of silicon particles are uniformly distributed in a composite whose structure is in the form of a single mass, for example, a polyhedral, spherical, or similar shape. It may comprise secondary silicon particles formed by combination of two or more silicon particles (primary silicon particles) with each other. The fluorine-containing magnesium compound may be present on the surface of the silicon particles or between the silicon particles. In addition, the fluorine-containing magnesium compound may be present inside the silicon particles.

In addition, the porous silicon composite according to an embodiment of the present invention may comprise pores. Specifically, pores may be contained on the surface, inside, or both of the silicon composite. In the process for preparing the porous silicon-carbon composite, the third step may comprise filtering and drying the composite obtained by the etching to obtain a porous silicon composite. The filtration and drying step may be carried out by a commonly used method.

In the process for preparing a porous silicon-carbon composite, the fourth step may comprise forming a carbon layer on the surface of the porous silicon composite by using a chemical thermal decomposition deposition method.

The electrical contact between the particles of the porous silicon-carbon composite may be enhanced by the step of formation of a carbon layer. In addition, as the charge and discharge proceed, excellent electrical conductivity may be imparted even after the electrode is expanded, so that the performance of the secondary battery can be further enhanced. Specifically, the carbon layer may increase the conductivity of the negative electrode active material to enhance the output characteristics and cycle characteristics of the battery and may increase the stress relaxation effect when the volume of the active material is changed.

The carbon layer may comprise at least one selected from the group consisting of graphene, reduced graphene oxide, a carbon nanotube, a carbon nanofiber, and graphite.

The step of formation of a carbon layer may be carried out by injecting at least one carbon source gas selected from compounds represented by the following Formulae 1 to 3 and carrying out a reaction of the porous silicon composite obtained in the third step in a gaseous state at 400°C to 1,200°C.

[Formula 1]  $C_NH_{(2N + 2-A)}[OH]_A$

In Formula 1, N is an integer of 1 to 20, and A is 0 or 1,

[Formula 2] $C_N H_{(2N-B)}$

in Formula 2, N is an integer of 2 to 6, and B is an integer of 0 to 2,

[Formula 3] $C_x H_y O_z$

in Formula 3, x is an integer of 1 to 20, y is an integer of 0 to 25, and z is an integer of 0 to 5.

In addition, in Formula 3, x may be the same as, or smaller than, y.

In addition, in Formula 3, y is an integer greater than 0 up to 25 or an integer of 1 to 25, and z is an integer greater than 0 up to 5 or an integer of 1 to 5.

The compound represented by Formula 1 may be at least one selected from the group consisting of methane, ethane, propane, butane, methanol, ethanol, propanol, propanediol, and butanediol. The compound represented by Formula 2 may be at least one selected from the group consisting of ethylene, propylene, butylene, butadiene, and cyclopentene. The compound represented by Formula 3 may be at least one selected from the group consisting of acetylene, benzene, toluene, xylene, ethylbenzene, naphthalene, anthracene, and dibutyl hydroxy toluene (BHT).

The carbon source gas may further comprise at least one inert gas selected from hydrogen, nitrogen, helium, and argon. The reaction may be carried out at 400°C to 1,200°C, specifically, 500°C to 1,100°C, more specifically, 600°C to 1,000°C.

The reaction time (or thermal treatment time) may be appropriately adjusted depending on the thermal treatment temperature, the pressure during the thermal treatment, the composition of the gas mixture, and the desired amount of carbon coating. For example, the reaction time may be 10 minutes to 100 hours, specifically, 30 minutes to 90 hours, more specifically, 50 minutes to 40 hours, but it is not limited thereto. Without being bound by a particular theory, as the reaction time is longer, the thickness of the carbon layer formed increases, which may enhance the electrical properties of the composite.

In the process for preparing a porous silicon-carbon composite according to an embodiment of the present invention, it is possible to form a thin and uniform carbon layer comprising at least one selected from graphene, reduced graphene oxide, a carbon nanotube, a carbon nanofiber, and graphite, specifically, at least one selected from graphene, reduced graphene oxide, a carbon nanotube, and a carbon nanofiber as a main component on the surface of the porous silicon composite even at a relatively low temperature through a gas-phase reaction of the carbon source gas. In addition, the detachment reaction in the carbon layer does not substantially take place.

In addition, since a carbon layer is uniformly formed over the entire surface of the silicon composite through the gas-phase reaction, a carbon film (carbon layer) having high crystallinity can be formed. Thus, when the porous silicon-carbon composite is used as a negative electrode active material, the electrical conductivity of the negative electrode active material can be enhanced without changing the structure.

According to an embodiment of the present invention, when a reactive gas containing the carbon source gas is supplied to the surface of the silicon composite, one or more graphene-containing materials selected from graphene, reduced graphene oxide, and graphene oxide, a carbon nanotube, or a carbon nanofiber is grown on the surface of the silicon particles. As the reaction time elapses, the graphene-containing material is gradually distributed and formed to obtain a porous silicon-carbon composite.

The specific surface area of the porous silicon-carbon composite may decrease according to the amount of carbon coating.

The structure of the graphene-containing material may be a layer, a nanosheet type, or a structure in which several flakes are mixed.

If a carbon layer comprising a graphene-containing material is uniformly formed over the entire surface of the silicon composite, it is possible to suppress volume expansion as a graphene-containing material that has enhanced conductivity and is flexible for volume expansion is directly grown on the surface of silicon particles or fluorine-containing magnesium compound. In addition, the coating of a carbon layer may reduce the chance that silicon directly meets the electrolyte, thereby reducing the formation of a solid electrolyte interphase (SEI) layer.

In addition, the porous silicon-carbon composite may have an average particle diameter ($D_{50}$) in the volume-based distribution measured by laser diffraction of 1 $\mu$m to 20 $\mu$m, 3 $\mu$m to 10 $\mu$m, or 3 $\mu$m to 8 $\mu$m. If $D_{50}$ is less than 1 $\mu$m, the bulk density is too small, and the charge and discharge capacity per unit volume may be deteriorated. On the other hand, if $D_{50}$ exceeds 20 $\mu$m, it is difficult to prepare an electrode layer, so that it may be peeled off from the electrical power collector. The average particle diameter ($D_{50}$) is a value measured as a diameter average value $D_{50}$, i.e., a particle size or median diameter when the cumulative volume is 50% in particle size distribution measurement according to a laser beam diffraction method.

In addition, according to an embodiment of the present invention, the process may further comprise crushing or pulverizing and classifying the porous silicon-carbon composite. The classification may be carried out to adjust the particle size distribution of the porous silicon-carbon composite, for which dry classification, wet classification, or classification using a sieve may be used. In the dry classification, the steps of dispersion, separation, collection (separation of solids and gases), and discharge are carried out sequentially or simultaneously using an air stream, in which pretreatment (adjustment of moisture, dispersibility, humidity, and the like) is carried out prior to the classification so as not to decrease the classification efficiency caused by interference between particles, particle shape, airflow disturbance, velocity distribution, and influence of static electricity, and the like, to thereby adjust the moisture or oxygen concentration in the air stream used. In addition, a desired particle size distribution may be obtained by carrying out crushing or pulverization and classification at one time. After the crushing or pulverization, it is effective to divide the coarse powder part and the granular part with a classifier or sieve.

A porous silicon-carbon composite powder having an average particle diameter of 1 μm to 20 μm, 3 μm to 8 μm, or 3 μm to 6 μm may be obtained through the crushing or pulverization and classification treatment.

The porous silicon-carbon composite powder may have a $D_{min}$ of 0.3 μm or less and a $D_{max}$ of 8 μm to 30 μm. Within the above range, the specific surface area of the composite may be reduced, and the initial efficiency and cycle characteristics may be enhanced by about 10% to 20% as compared with before classification. The composite powder upon the crushing or pulverization and classification has an amorphous grain boundary and a crystal grain boundary, so that particle collapse by a charge and discharge cycle may be reduced by virtue of the stress relaxation effect of the amorphous grain boundary and the crystal grain boundary. When such silicon particles are used as a negative electrode active material of a secondary battery, the negative electrode active material of the secondary battery can withstand the stress of a change in volume expansion caused by charge and discharge and can exhibit characteristics of a secondary battery having a high capacity and a long lifespan. In addition, a lithium-containing compound such as $Li_2O$ present in the SEI layer formed on the surface of a silicon-based negative electrode may be reduced.

According to an embodiment of the present invention, depending on before and after the etching step, that is, physical properties such as element content and specific surface area in the silicon composite oxide before the etching and the silicon composite or silicon-carbon composite after the etching may vary.

For example, the molar ratio (O/Si) of oxygen (O) atoms to silicon (Si) atoms present in the porous silicon-carbon composite may be 0.01 to less than 1. In addition, the molar ratio (O/Si) of oxygen (O) atoms to silicon (Si) atoms present in the porous silicon-carbon composite may be 0.02 to 0.90 or 0.03 to 0.6.

In such a case, it is possible to significantly lower the oxygen fraction of the porous silicon-carbon composite and to reduce the surface resistance thereof. As a result, when the composite is applied to a negative electrode active material, the electrochemical properties, particularly, the initial efficiency characteristics of a lithium secondary battery can be remarkably improved.

In addition, the content of oxygen (O) in the porous silicon-carbon composite may be further reduced by 5% by weight to 95% by weight, specifically, 5% by weight to 75% by weight, as compared with the content of oxygen (O) in the silicon composite oxide.

The process according to an embodiment of the present invention has an advantage in that mass production is possible through a continuous process with minimized steps.

A secondary battery using the porous silicon-carbon composite as a negative electrode may enhance its capacity, capacity retention rate, and initial efficiency.

**Negative electrode active material**

The negative electrode active material according to an embodiment of the present invention may comprise the porous silicon-carbon composite. That is, the negative electrode active material may comprise a porous silicon-carbon composite comprising silicon particles fluorine-containing magnesium compound, and carbon.

In addition, the negative electrode active material may further comprise a carbon-based negative electrode material, specifically, a graphite-based negative electrode material.

The negative electrode active material may be used as a mixture of the porous silicon-carbon composite and the carbon-based negative electrode material, for example, a graphite-based negative electrode material. In such an event, the electrical resistance of the negative electrode active material can be reduced, while the expansion stress involved in charging can be relieved at the same time. The carbon-based negative electrode material may comprise, for example, at least one selected from the group consisting of natural graphite, synthetic graphite, soft carbon, hard carbon, mesocarbon, carbon fiber, carbon nanotube, pyrolytic carbon, coke, glass carbon fiber, sintered organic high molecular compound, and carbon black.

The content of the carbon-based negative electrode material may be 30% by weight to 90% by weight, specifically, 30% by weight to 80% by weight, more specifically, 50% by weight to 80% by weight, based on the total weight of the negative electrode active material.

**Secondary battery**

According to an embodiment of the present invention, the present invention may provide a negative electrode comprising the negative electrode active material and a secondary battery comprising the same.

The secondary battery may comprise a positive electrode, a negative electrode, a separator interposed between the positive electrode and the negative electrode, and a non-aqueous liquid electrolyte in which a lithium salt is dissolved. The negative electrode may comprise a negative electrode active material comprising a porous silicon-carbon composite.

The negative electrode may be composed of a negative electrode mixture only or may be composed of a negative electrode current collector and a negative electrode mixture layer (negative electrode active material layer) supported thereon. Similarly, the positive electrode may be composed of a positive electrode mixture only or may be composed of a positive electrode current collector and a positive electrode mixture layer (positive electrode active material layer) supported thereon. In addition, the negative electrode mixture and the positive electrode mixture may further comprise a conductive material and a binder.

Materials known in the field may be used as the material constituting the negative electrode current collector and the material constituting the positive electrode current collector. Materials known in the field may be used as the binder and the conductive material added to the negative electrode and the positive electrode.

If the negative electrode is composed of a current collector and an active material layer supported thereon, the negative electrode may be prepared by coating the negative electrode active material composition comprising the porous silicon-carbon composite on the surface of the current collector and drying it.

In addition, the secondary battery comprises a non-aqueous liquid electrolyte in which the non-aqueous liquid electrolyte may comprise a non-aqueous solvent and a lithium salt dissolved in the non-aqueous solvent. A solvent commonly used in the field may be used as a non-aqueous solvent. Specifically, an aprotic organic solvent may be used. Examples of the aprotic organic solvent include cyclic carbonates such as ethylene carbonate, propylene carbonate, and butylene carbonate, cyclic carboxylic acid esters such as furanone, chain carbonates such as diethyl carbonate, ethylmethyl carbonate, and dimethyl carbonate, chain ethers such as 1,2-methoxyethane, 1,2-ethoxyethane, and ethoxymethoxyethane, and cyclic ethers such as tetrahydrofuran and 2-methyltetrahydrofuran. They may be used alone or in combination of two or more.

The secondary battery may comprise a non-aqueous secondary battery.

The negative electrode active material and the secondary battery using the porous silicon-carbon composite may enhance the capacity, initial charge and discharge efficiency, and capacity retention rate thereof.

**Mode for Carrying out the Invention**

Hereinafter, the present invention will be described in detail with reference to examples. The following examples are only illustrative of the present invention, and the scope of the present invention is not limited thereto.

**Example**

**<Example 1>**

**Preparation of a porous silicon-carbon composite**

(1) Step 1: A silicon composite oxide powder having the element content and physical properties shown in Table 1 below was prepared using a silicon powder, a silicon dioxide powder, and metallic magnesium by the method described in Example 1 of Korean Laid-open Patent Publication 10-2018-0106485.

(2) Step 2: 50 g of the silicon composite oxide powder was dispersed in water, which was stirred at a speed of 300 rpm, and 400 ml of an aqueous solution of 30% by weight of HF was added as an etching solution to etch the silicon composite oxide powder.

(3) Step 3: The porous composite obtained by the above etching was filtered and dried at 150°C for 2 hours. Then, in order to control the particle size of the porous composite, it was crushed using a mortar to have an average particle diameter of 5.8 $\mu$m, to thereby prepare a porous silicon composite (B1).

(4) Step 4: 10 g of the porous silicon composite was placed inside a tubular electric furnace, and argon (Ar) and methane gas were flowed at a rate of 1 liter/minute, respectively. It was maintained at 900°C for 1 hour and then cooled to room temperature, whereby the surface of the porous silicon composite was coated with carbon, to thereby prepare a porous silicon-carbon composite having the content of each component and physical properties shown in Table 3 below.

(5) Step 5: In order to control the particle size of the porous silicon-carbon composite, it was crushed and classified to have an average particle diameter of 6.1 $\mu$m by a mechanical method. A porous silicon-carbon composite (C1) was prepared.

**Manufacture of a secondary battery**

A negative electrode and a battery (coin cell) comprising the porous silicon-carbon composite as a negative electrode active material were prepared.

The negative electrode active material, Super-P as a conductive material, and polyacrylic acid were mixed at a weight ratio of 80:10:10 with water to prepare a negative electrode active material composition having a solids content of 45%.

The negative electrode active material composition was applied to a copper foil having a thickness of 18 $\mu$m and dried to prepare an electrode having a thickness of 70 $\mu$m. The copper foil coated with the electrode was punched in a circular shape having a diameter of 14 mm to prepare a negative electrode plate for a coin cell.

Meanwhile, a metallic lithium foil having a thickness of 0.3 mm was used as a positive electrode plate.

A porous polyethylene sheet having a thickness of 25 $\mu$m was used as a separator. A liquid electrolyte in which $LiPF_6$ had been dissolved at a concentration of 1 M in a mixed solvent of ethylene carbonate (EC) and diethylene carbonate (DEC) at a volume ratio of 1:1 was used as an electrolyte. The above components were employed to manufacture a coin cell (battery) having a thickness of 3.2 mm and a diameter of 20 mm.

**<Examples 2 to 11>**

As shown in Tables 1 to 3 below, a porous silicon-carbon composite was prepared in the same manner as in Example 1 and a secondary battery using the same was manufactured, except that a silicon composite oxide powder having the element content and physical properties shown in Table 1 below was used and that the type of dispersion medium, etching conditions, and the type and amount of carbon source gas were changed to adjust the content of each component and the physical properties of the composite.

**<Comparative Example 1>**

As shown in Tables 1 to 3 below, a negative electrode active material and a secondary battery using the same were prepared in the same manner as in Example 1, except that a silicon-containing oxide having the element content and physical properties shown in Table 1 below was used and that the etching process of step (2) and the coating process of step (4) were not carried out.

**<Comparative Example 2>**

As shown in Tables 1 to 3 below, a negative electrode active material and a secondary battery using the same were prepared in the same manner as in Example 1, except that the etching process of step (2) was not carried out.

**<Comparative Example 3>**

As shown in Tables 1 to 3 below, a negative electrode active material and a secondary battery using the same were prepared in the same manner as in Example 11, except that the etching process of step (2) in Example 11 was not carried out.

**Test Example**

**<Test Example 1> Electron microscope analysis**

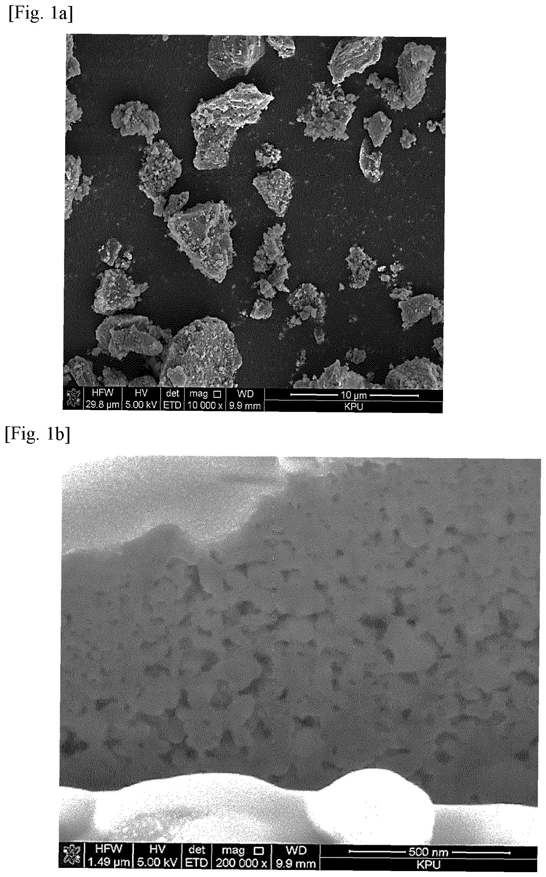

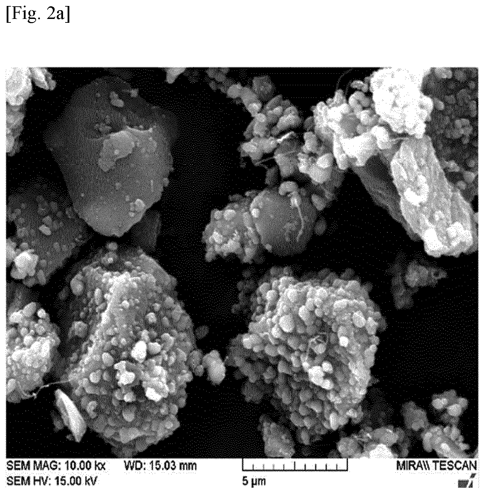

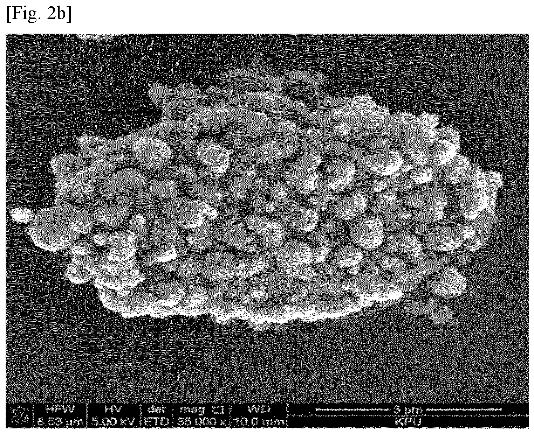

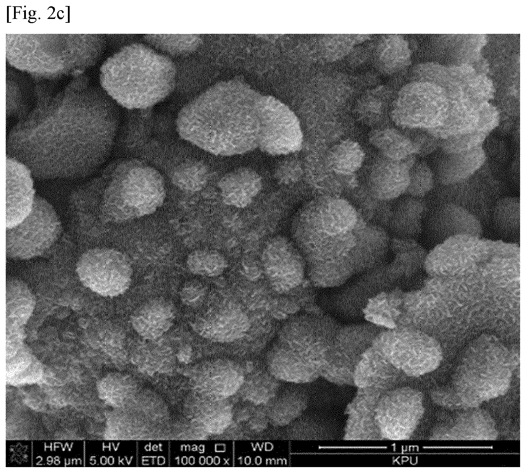

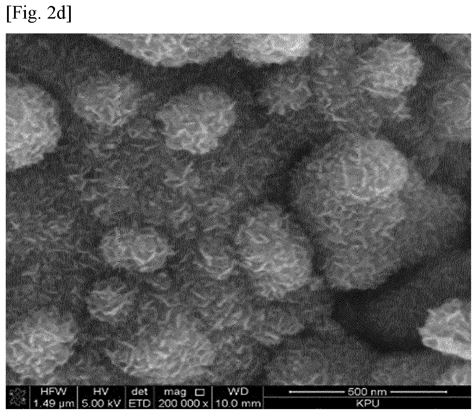

The surfaces of the porous silicon composite (composite B1) and the porous silicon-carbon composite (composite C1) prepared in Example 1 were observed using a scanning electron microscope (FE-SEM) photograph (S-4700, Hitachi), respectively. The results are shown in Figs. 1a and 2, respectively.

Referring to Fig. 1a, pores were present on the surface of the porous silicon composite (composite B1) prepared in Example 1.

In addition, referring to Fig. 2, field emission scanning electron microscope (FE-SEM) photographs of the surface of the porous silicon-carbon composite (composite C1) comprising a carbon layer on the surface of the porous silicon composite according to the magnification are shown in Figs. 2a to 2d, respectively. As can be seen from Figs. 2a to 2d, when Figs. 1a and 2 are compared, there was a difference in the surfaces of the composites, whereby it was confirmed that a carbon layer was formed on the surface of the secondary silicon particles formed as the silicon particles had been aggregated.

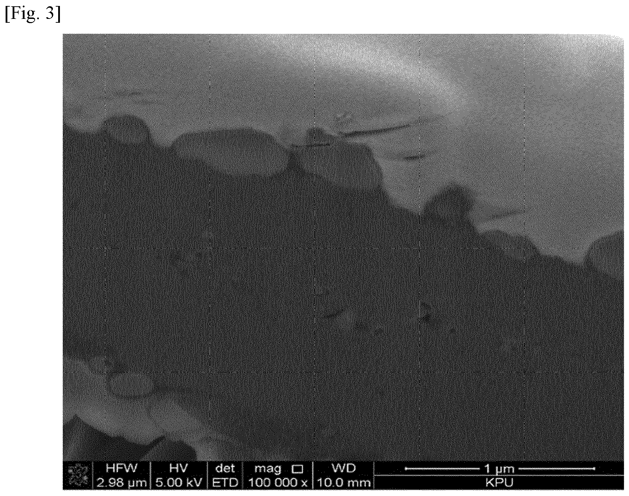

Meanwhile, the insides of the porous silicon composite (composite B 1) and the porous silicon-carbon composite (composite C1) prepared in Example 1 were observed using an ion beam scanning electron microscope (FIB-SEM) photograph (S-4700, Hitachi; QUANTA 3D FEG, FEI), respectively. The results are shown in Figs. 1b and 3, respectively.

Referring to Fig. 1b, pores were present in the inside of the porous silicon composite (composite B 1) prepared in Example 1. It can be inferred from Fig. 1b that pores were formed by the etching solution that penetrated into the porous silicon composite.

In addition, referring to Fig. 3, as a result of observing the inside of the porous silicon-carbon composite (composite C1) comprising a carbon layer on the surface of the porous silicon composite, pores were observed inside the porous silicon composite even after the carbon coating layer was formed on the surface of the porous silicon composite.

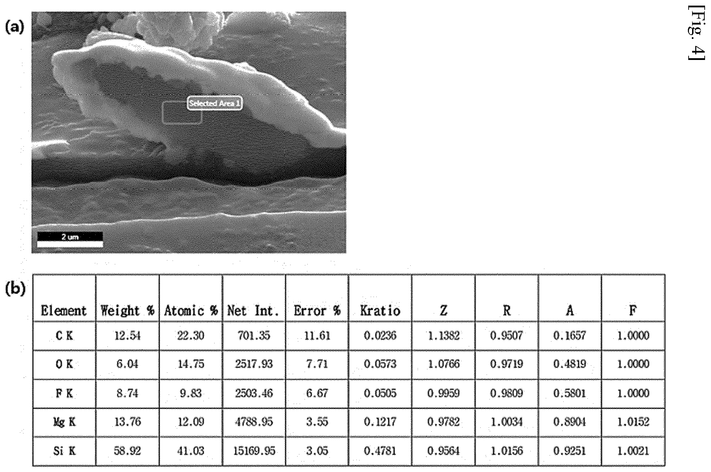

Meanwhile, Fig. 4 is an FIB-SEM EDAX (S-4700, Hitachi; QUANTA 3D FEG, FEI; EDS System, EDAX) photograph (a) of the porous silicon-carbon composite (composite C1) prepared in Example 1 and a table (b) of an analysis of the components in the composite.

Referring to Fig. 4(b), when carbon coating with methane was carried out after etching, about 15% of carbon content to the inside of the porous silicon-carbon composite was confirmed, suggesting that carbon was coated to the inner pores after methane coating.

In addition, as shown in the table of Fig. 4(b) of the component analysis, Mg, F, C, O, and Si components were observed in the porous silicon-carbon composite of Example 1.

**<Test Example 2> Thickness analysis of a carbon layer**

The thickness of the carbon-containing carbon layer of the porous silicon-carbon composite (composite C1) of Example 1 was analyzed.

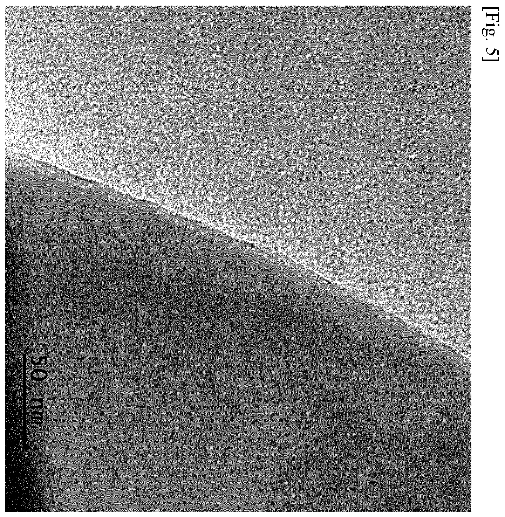

Fig. 5 shows the results of a transmission electron microscope (TEM/EDS) analysis of the porous silicon-carbon composite (composite C1) prepared in Example 1.

To use TEM/EDS, milling was carried out using an [FC-FI20]-FIB II device, and then the thickness of the carbon layer was analyzed using TEM.

As a result of the analysis in Fig. 5 and Table 3 below, the content of carbon in the porous silicon-carbon composite of Example 1 was 34.9% by weight and the carbon layer had a thickness of about 20 nm to 30 nm when coated with methane gas.

**<Test Example 3> X-ray diffraction analysis**

The crystal structures of the silicon composite oxide (composite A), the porous silicon composite (composite B), and the porous silicon-carbon composite (composite C) prepared in the examples were analyzed with an X-ray diffraction analyzer (Malvern Panalytical, X'Pert3).

Specifically, the applied voltage was 40 kV and the applied current was 40 mA. The range of $2\theta$ was 10° to 90°, and it was measured by scanning at an interval of 0.05°.

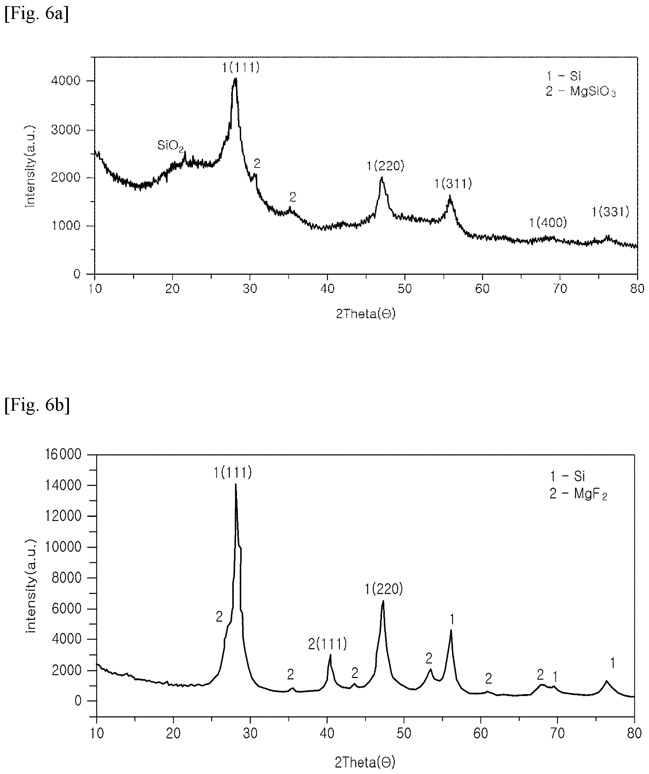

Figs. 6a to 6c show the measurement results of an X-ray diffraction analysis of the silicon composite oxide (composite A1) (6a), the porous silicon composite (composite B1) (6b), and the porous silicon-carbon composite (composite C1) (6c) of Example 1.

Referring to Fig. 6a, as can be seen from the X-ray diffraction pattern, the silicon composite oxide (composite A1) of Example 1 had a peak corresponding to $SiO_2$ around a diffraction angle ($2\theta$) of 21.7°; peaks corresponding to Si crystals around diffraction angles ($2\theta$) of 28.1°, 47.0°, 55.8°, 68.6°, and 76.1°; and peaks corresponding to $MgSiO_3$ crystals around diffraction angles ($2\theta$) of 30.4° and 35.0°, which confirms that the silicon composite oxide comprised amorphous $SiO_2$, crystalline Si, and $MgSiO_3$.

Referring to Fig. 6b, as can be seen from the X-ray diffraction pattern, the porous silicon composite (composite B1) of Example 1 had peaks corresponding to $MgF_2$ crystals around diffraction angles ($2\theta$) of 27.1°, 35.2°, 40.4°, 43.5°, 53.3°, 60.9°, and 67.9°; and peaks corresponding to Si crystals around diffraction angles ($2\theta$) of 28.1°, 47.0°, 55.8°, 68.6°, and 76.1°. In addition, as the peak corresponding to $MgSiO_3$ disappeared and the peak corresponding to $MgF_2$ appeared, it can be seen that $MgSiO_3$ was converted to $MgF_2$ upon etching.

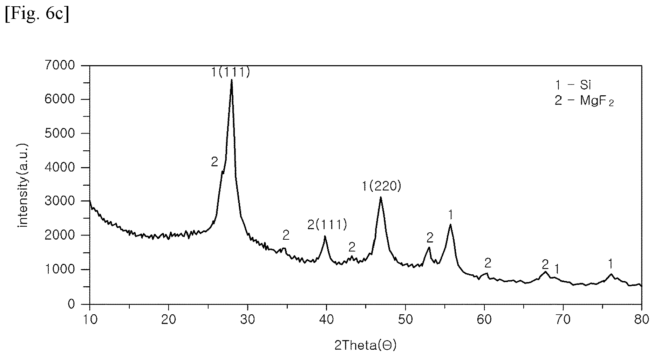

Referring to Fig. 6c, as can be seen from the X-ray diffraction pattern, the porous silicon-carbon composite (composite C1) of Example 1 had peaks corresponding to $MgF_2$ crystals around diffraction angles ($2\theta$) of 27.1°, 35.2°, 40.4°, 43.5°, 53.3°, 60.9°, 67.9°, and 76.4°; and peaks corresponding to Si crystals around diffraction angles ($2\theta$) of 28.1°, 47.0°, 55.8°, 68.6°, and 76.1°. There was no significant change other than the change in intensity before and after the carbon coating. The diffraction angle ($2\theta$) of carbon could not be confirmed since it overlapped with the Si (111) peak.

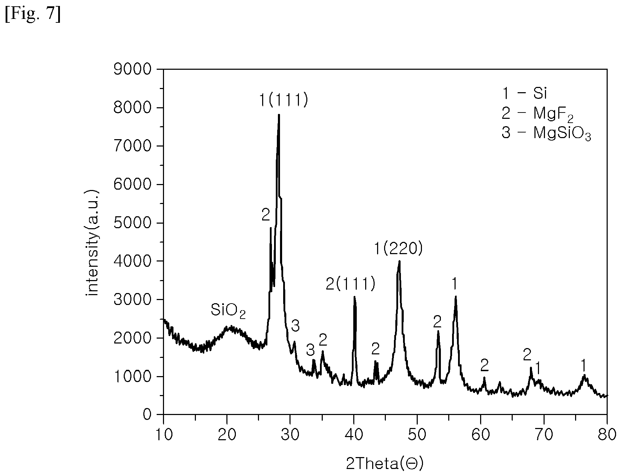

Fig. 7 shows the measurement results of an X-ray diffraction analysis of the porous silicon-carbon composite (composite C2) of Example 2.

Referring to Fig. 7, as can be seen from the X-ray diffraction pattern, the silicon-carbon composite oxide (composite C2) of Example 2 had a peak corresponding to $SiO_2$ around a diffraction angle ($2\theta$) of 21.7°; peaks corresponding to Si crystals around diffraction angles ($2\theta$) of 28.1°, 47.0°, 55.8°, 68.6°, and 76.1°; peaks corresponding to $MgSiO_3$ crystals around diffraction angles ($2\theta$) of 30.4° and 35.0°, and peaks corresponding to $MgF_2$ crystals around diffraction angles ($2\theta$) 26.9°, 34.8°, 40.1°, 43.4°, 53.1°, 60.3°, and 67.8°, which confirms that it comprised $SiO_2$, crystalline Si, $MgSiO_3$, and $MgF_2$. In addition, the diffraction angle ($2\theta$) of carbon could not be confirmed since it overlapped with the Si (111) peak.

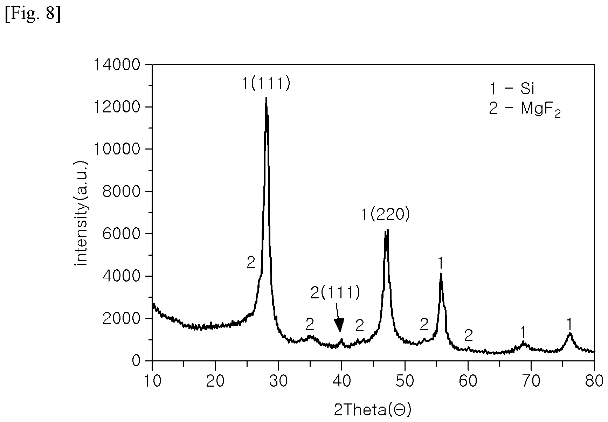

Fig. 8 shows the measurement results of an X-ray diffraction analysis of the porous silicon-carbon composite (composite C5) of Example 5.

Referring to Fig. 8, as can be seen from the X-ray diffraction pattern, the porous silicon-carbon composite (composite C5) of Example 5 had peaks corresponding to $MgF_2$ crystals around diffraction angles ($2\theta$) of 28.0°, 34.9°, 40.1°, 43.4°, 53.0°, and 60.2°; and peaks corresponding to Si crystals around diffraction angles ($2\theta$) of 28.1°, 28.1°, 47.1°, 55.8°, 68.9°, and 76.4°. In addition, the diffraction angle ($2\theta$) of carbon could not be confirmed since it overlapped with the Si (111) peak.

Meanwhile, the crystal size of Si in the obtained porous silicon-carbon composite was determined by the Scherrer equation of the following Equation 1 based on a full width at half maximum (FWHM) of the peak corresponding to Si (220) in the X-ray diffraction analysis.

$$[\text{Equation 1}]$$

$$\text{Crystal size (nm)} = K\lambda/B\cos\theta$$

In Equation 1, K is 0.9, $\lambda$ is 0.154 nm, B is a full width at half maximum (FWHM), and $\theta$ is a peak position (angle).

**<Test Example 4> Analysis of the content and specific gravity of the component elements of the composites**

The content of each component element of magnesium (Mg), silicon (Si), oxygen (O), and carbon (C) in the composites prepared in the Examples and Comparative Examples were analyzed.

The contents of magnesium (Mg) and silicon (Si) were analyzed by inductively coupled plasma (ICP) emission spectroscopy using Optima-5300 of PerkinElmer. The content of oxygen (O) was measured by O-836 of LECO, and an average of three measurements was obtained. The content of carbon (C) was analyzed by CS-744 elemental analyzer of LECO. The content of fluorine (F) was a value calculated based on the contents of silicon (Si), oxygen (O), and magnesium (Mg).

In addition, the specific gravity (true specific gravity) was measured 5 times by filling 2/3 of a 10 ml container with the prepared composite using Accupyc II 1340 of Micromeritics.

**<Test Example 5> Measurement of an average particle diameter of composite particles**

The average particle diameter ($D_{50}$) of the composite particles prepared in the Examples and Comparative Examples was measured as a diameter average value $D_{50}$, i.e., a particle size or median diameter when the cumulative volume is 50% in particle size distribution measurement according to a laser beam diffraction method.

**<Test Example 6> Raman spectroscopic analysis**

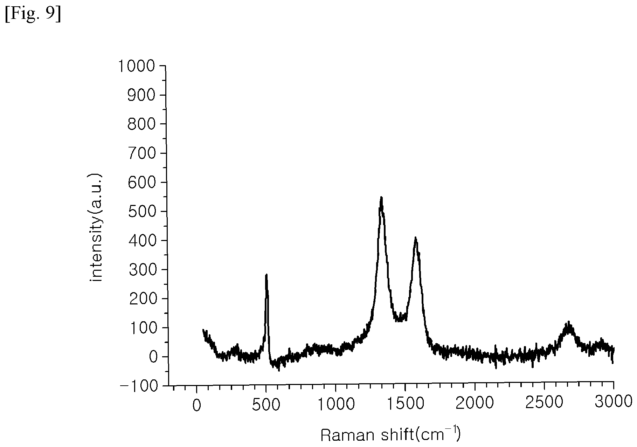

The porous silicon-carbon composite prepared in Example 1 was subjected to a Raman spectroscopic analysis. Raman analysis was carried out using a micro Raman analyzer (Renishaw, RM1000-In Via) at 2.41 eV (514 nm). The results are shown in Fig. 9.

Referring to Fig. 9, the Raman spectrum obtained by Raman spectroscopy had a 2D band peak in the range of 2,600 $cm^{-1}$ to 2,760 $cm^{-1}$, a G band peak in the range of 1,500 $cm^{-1}$ to 1,660 $cm^{-1}$, and a D band peak in the range of 1,300 $cm^{-1}$ to 1,460 $cm^{-1}$. When the intensity of the 2D band peak is $I_{2D}$, the intensity of the D band peak is $I_D$, and the intensity of the G band peak is $I_G$, $I_D$, $I_{2D}$, and $I_G$ were 536, 102, and 402, respectively, and $(I_{2D} + I_G)/I_D$ was 0.94.

It can be seen from the results of Raman spectroscopic analysis that the carbon layer had $I_D$, $I_{2D}$, and $I_G$ of the above values, so that the conductivity was good and the characteristics of the secondary battery could be enhanced. In particular, as $(I_{2D} + I_G)/I_D$ was 0.94, it was possible to suppress side reactions during charge and discharge and to suppress a deterioration in the initial efficiency.

Accordingly, the porous silicon-carbon composite prepared in Example 1 was excellent in conductivity, and the performance of the lithium secondary battery could be remarkably enhanced.

**<Test Example 7> Analysis of specific surface area**

The composites prepared in the Examples and Comparative Examples were placed in a tube and treated with a pretreatment device (BELPREP-vac2) of MicrotracBEL at $10^{-2}$ kPa and 100°C for 5 hours.

Upon the pretreatment, the tube was mounted on the analysis port of an analysis device (BELSORP-max) to carry out a specific surface area analysis.

**<Test Example 8> Measurement of capacity, initial efficiency, and capacity retention rate of secondary batteries**

The coin cells (secondary batteries) prepared in the Examples and Comparative Examples were each charged at a constant current of 0.1 C until the voltage reached 0.005 V and discharged at a constant current of 0.1 C until the voltage reached 2.0 V to measure the charge capacity (mAh /g), discharge capacity (mAh/g), and initial efficiency (%). The results are shown in Table 4 below.

[Equation 2]

$$\text{Initial efficiency (\%)} = \text{discharge capacity/charge capacity} \times 100$$

In addition, the coin cells prepared in the Examples and Comparative Examples were each charged and discharged once in the same manner as above and, from the second cycle, charged at a constant current of 0.5 C until the voltage reached 0.005 V and discharged at a constant current of 0.5 C until the voltage reached 2.0 V to measure the cycle characteristics (capacity retention rate for 50 cycles, %). The results are shown in Table 4 below.

[Equation 3]

$$\text{Capacity retention rate for 50 cycles (\%)} = 51^{\text{th}} \text{ discharge capacity/} 2^{\text{nd}} \text{ discharge capacity} \times 100$$

The content of each element and physical properties of the composites prepared in the Examples and Comparative Examples are summarized in Tables 1 to 3 below. The characteristics of the secondary batteries using the same are summarized in Table 4 below.

[Table 1]

| Silicon composite oxide (Composite A) | | Example | | | | | | | | | | | | Comparative Example | | |
|---|---|---|---|---|---|---|---|---|---|---|---|---|---|---|---|---|
| | | 1 | 2 | 3 | 4 | 5 | 6 | 7 | 8 | 9 | 10 | 11 | 1 | 2 | 3 |
| | Name | A1 | | | | A2 | | | A3 | | A4 | A5 | silicon-containing oxide | A1 | A5 |
| | Si content (% by weight) | 61.6 | | | | 64.4 | | | 63.8 | | 60.3 | 59.3 | 63.0 | 61.6 | 59.3 |
| | Mg content (% by weight) | 5.3 | | | | 0.8 | | | 2 | | 8 | 15 | 0 | 5.3 | 15 |
| | O content (% by weight) | 33.1 | | | | 34.8 | | | 34.2 | | 31.7 | 25.7 | 37 | 33.1 | 25.7 |
| | Avg. particle diameter D50 ($\mu$m) | 5.9 | | | | 5.0 | | | 5.0 | | 5.5 | 6.0 | 5.1 | 5.9 | 6.0 |
| | Specific gravity (g/cm3) | 2.46 | | | | 2.36 | | | 2.39 | | 2.52 | 2.64 | 2.32 | 2.46 | 2.64 |
| | BET (m$^2$/g) | 10.8 | | | | 6.6 | | | 4.84 | | 5.4 | 6.7 | 5.8 | 10.8 | 6.7 |

[Table 2]

| Porous silicon composite (Composite B) | | Example | | | | | | | | | | | Comp. Ex. | | |
|---|---|---|---|---|---|---|---|---|---|---|---|---|---|---|---|
| | | 1 | 2 | 3 | 4 | 5 | 6 | 7 | 8 | 9 | 10 | 11 | 1 | 2 | 3 |
| | Name | B1 | B2 | | B3 | B4 | | | B5 | B6 | B7 | B8 | | | |
| | Oxygen reduction rate (%) | 85 | 26 | | 42 | 94 | | | 89 | 42 | 47 | 31 | | | |
| | $MgF_2$(111)/Si (220) | 0.25 | 0.08 | | 0.13 | 0.46 | | | 0.1 | 0.17 | 0.04 | 0.56 | | | |
| | Mg content (% by weight) | 5.73 | 7.1 | | 5.26 | 3.4 | | | 1.42 | 1.87 | 6.5 | 11.8 | | | |
| | Si content (% by weight) | 81.7 | 64.1 | | 72.1 | 88.7 | | | 92.8 | 77.1 | 67.6 | 52.2 | | | |
| | Specific gravity (g/cm3) | 2.02 | 2.35 | | 2.22 | 1.76 | | | 1.88 | 2.04 | 2.42 | 2.52 | | | |
| | BET ($m^2$/g) | 492 | 54.8 | | 263.4 | 719 | | | 632 | 274.25 | 93.1 | 102 | | | |

[Table 3]

| | | | Example | | | | | | | | | | | Comp. Ex. | | |
|---|---|---|---|---|---|---|---|---|---|---|---|---|---|---|---|---|---|
| | | | 1 | 2 | 3 | 4 | 5 | 6 | 7 | 8 | 9 | 10 | 11 | 1 | 2 | 3 |
| Porous silicon-carbon composite (Composite C) | | Name | C1 | C2 | C3 | C4 | C5 | C6 | C7 | C8 | C9 | C10 | C11 | | C12 | C13 |
| | | C content (% by weight) | 34.9 | 7.1 | 16.1 | 33.1 | 26 | 38.5 | 75 | 30.7 | 28.7 | 27.1 | 25.5 | | 5.8 | 5 |
| | | Si content (% by weight) | 53.07 | 59.55 | 53.78 | 47.4 | 65.64 | 54.55 | 22.18 | 63.23 | 55.31 | 49.28 | 38.9 | | 58.03 | 55.1 |
| | | Mg content (% by weight) | 3.73 | 6.6 | 5.96 | 3.52 | 2.52 | 2.09 | 0.85 | 0.98 | 1.33 | 4.74 | 8.8 | | 4.99 | 6.65 |
| | | O content (% by weight) | 3.35 | 22.67 | 20.47 | 13.6 | 1.92 | 1.6 | 0.65 | 3.7 | 13.8 | 12.1 | 13 | | 31.18 | 33.25 |
| | | F content (% by weight) | 4.95 | 4.1 | 3.7 | 2.34 | 3.92 | 3.26 | 1.32 | 1.38 | 0.86 | 6.78 | 13.8 | - | 0 | 0 |
| | | Si crystallite size (nm) (220) | 9.62 | 10.7 | 9.63 | 7.87 | 9.63 | 8.1 | 11.8 | 10.9 | 6.5 | 9.1 | 15.9 | | 7.1 | 15.9 |
| | | $MgF_2$ (111) / Si (220) | 0.366 | 0.707 | 0.56 | 0.488 | 0.071 | 0.233 | 0.04 | 0.123 | 0.307 | 0.037 | 0.53 | | - | - |
| | | $MgF_2$ crystallite size (nm) | 26.4 | 28.19 | 22.86 | 21.1 | 18 | 21.1 | 21.8 | 32.5 | 11.4 | 12.7 | 14.3 | | - | - |
| | | Specific gravity (g/cm3) | 1.96 | 2.41 | 2.24 | 2.05 | 2.03 | 2.35 | 2.18 | 1.98 | 2.19 | 2.08 | 2.47 | | 2.27 | 2.64 |
| | | D50 ($\mu$m) | 6.1 | 7.92 | 7.43 | 9.7 | 11.87 | 8.24 | 13.7 | 10.63 | 8.1 | 10.3 | 8.7 | | 7.0 | 6.0 |
| | | BET ($m^2$/g) | 13.6 | 9.7 | 10.6 | 22.8 | 6.8 | 15.4 | 4.7 | 13 | 23.5 | 12.7 | 12.2 | | 2.9 | 5.6 |

[Table 4]

| | | Example | | | | | | | | | | | Comp. Ex. | | |
|---|---|---|---|---|---|---|---|---|---|---|---|---|---|---|---|
| | | 1 | 2 | 3 | 4 | 5 | 6 | 7 | 8 | 9 | 10 | 11 | 1 | 2 | 3 |
| Secondary battery characteristics | Discharge capacity (mAh/g) | 1702 | 1553 | 1490 | 1575 | 2074 | 1683 | 1681 | 1922 | 1644 | 1456 | 1398 | 1420 | 1443 | 1219 |
| | Initial efficiency (%) | 90 | 82.6 | 82.8 | 83.6 | 90.8 | 86.2 | 88.3 | 91.4 | 80.8 | 85.1 | 87.4 | 62.2 | 79.6 | 83.9 |
| | Capacity retention rate after 50 cycles (%) | 84.1 | 83.8 | 83.9 | 82.3 | 89.1 | 87.9 | 85.2 | 89.5 | 86.6 | 82.1 | 83.7 | 59.2 | 81 | 80.1 |

As can be seen from Table 4 above, the secondary batteries prepared using the porous silicon-carbon composites of Examples 1 to 11 of the present invention were significantly enhanced in performance in terms of discharge capacity, initial efficiency, and cycle characteristics as compared with Comparative Examples 1 to 3.

Specifically, the secondary batteries of Examples 1 to 11 had an overall excellent discharge capacity of 1,398 mAh/g to 2,074 mAh/g, in particular, an initial efficiency of 80.8% to 91.4% and a capacity retention rate of 82.1% to 89.5% upon 50 cycles.

In contrast, the secondary battery of Comparative Example 1 using silicon-containing oxide had an initial efficiency of 62.2% and a capacity retention rate of 59.2% upon 50 cycles, indicating that the initial efficiency and capacity retention rate were significantly reduced as compared with the secondary batteries of the Examples.

Meanwhile, when the secondary battery of Example 1 and the secondary battery of Comparative Example 2 in which only etching was not carried out in the process of Example 1 are compared, the secondary battery of Example 1 had a discharge capacity of 1,702 mAh/g, an initial efficiency of 90%, and a capacity retention rate of 84.1% upon 50 cycles, whereas the secondary battery of Comparative Example 2 had a discharge capacity of 1,443 mAh/g, an initial efficiency of 79.6%, and a capacity retention rate of 81% upon 50 cycles, indicating that the latter was significantly reduced in the discharge capacity, initial efficiency, and capacity retention rate as compared with the former of Example 1.

In addition, when the secondary battery of Example 11 and the secondary battery of Comparative Example 3 in which only etching was not carried out in the process of Example 11 are compared, the secondary battery of Example 11 had a discharging capacity of 1,398 mAh/g, an initial efficiency of 87.4%, and a capacity retention rate of 83.7% upon 50 cycles, whereas the secondary battery of Comparative Example 3 had a discharge capacity of 1,219 mAh/g, an initial efficiency of 83.9%, and a capacity retention rate of 80.1% upon 50 cycles, indicating that the latter was significantly reduced in the discharging capacity, initial efficiency, and capacity retention rate as compared with the former of Example 11.

Accordingly, it was confirmed that, in the secondary battery of Comparative Example 1 in which magnesium fluoride and carbon were not employed and that of Comparative Examples 2 and 3 in which magnesium fluoride was not employed, the performance of the secondary batteries was overall reduced as compared with the secondary batteries of the Examples.

## Claims

1. A porous silicon-carbon composite, which comprises a silicon particle, fluorine-containing magnesium compound, and carbon.

2. The porous silicon-carbon composite of claim 1, wherein the porous silicon-carbon composite comprises pores inside thereof, and the porosity of the pores in the porous silicon-carbon composite is 0.1% by volume to 40% by volume based on the volume of the porous silicon-carbon composite.

3. The porous silicon-carbon composite of claim 1, wherein the fluorine-containing magnesium compound comprises magnesium fluoride ($MgF_2$), magnesium fluoride silicate ($MgSiF_6$), or a mixture thereof.

4. The porous silicon-carbon composite of claim 3, wherein the crystallite size of the magnesium fluoride ($MgF_2$) as measured by an X-ray diffraction analysis is 2 nm to 35 nm.

5. The porous silicon-carbon composite of claim 1, which further comprises magnesium silicate.

6. The porous silicon-carbon composite of claim 5, wherein the magnesium silicate comprises an $MgSiO_3$ crystal, an $Mg_2SiO_4$ crystal, or a mixture thereof.

7. The porous silicon-carbon composite of claim 1, wherein the content of magnesium (Mg) in the porous silicon-carbon composite is 0.5% by weight to 20% by weight based on the total weight of the porous silicon-carbon composite.

8. The porous silicon-carbon composite of claim 3, which, in an X-ray diffraction analysis, has an IB/IA of greater than 0 to 1, the IB/IA being a ratio of the diffraction peak intensity (IB) for an $MgF_2$ (111) crystal plane to the diffraction peak intensity (IA) for an Si (220) crystal plane.

9. The porous silicon-carbon composite of claim 1, which further comprises a silicon oxide compound.

10. The porous silicon-carbon composite of claim 9, wherein the silicon oxide compound is $SiO_x$ ($0.5 \leq x \leq 2$).

11. The porous silicon-carbon composite of claim 1, wherein the content of silicon (Si) is 8% by weight to 95% by weight based on the total weight of the porous silicon-carbon composite.

12. The porous silicon-carbon composite of claim 1, wherein the silicon particle is in an amorphous form, a crystalline form having a crystallite size of 2 nm to 20 nm, or a mixture thereof.

13. The porous silicon-carbon composite of claim 1, wherein the porous silicon-carbon composite comprises a silicon composite and a carbon layer on its surface, the silicon particle and fluorine-containing magnesium compound are present in the silicon composite, and the carbon is present on a part or the entirety of the surfaces of the silicon particle and fluorine-containing magnesium compound to form a carbon layer.

14. The porous silicon-carbon composite of claim 13, wherein the molar ratio (O/Si) of oxygen atoms to silicon atoms present in the porous silicon-carbon composite is 0.01 to less than 1.

15. The porous silicon-carbon composite of claim 13, wherein the carbon layer comprises at least one selected from the group consisting of graphene, reduced graphene oxide, a carbon nanotube, a carbon nanofiber, and graphite.

16. The porous silicon-carbon composite of claim 1, wherein the content of carbon (C) is 3% by weight to 80% by weight based on the total weight of the porous silicon-carbon composite.

17. The porous silicon-carbon composite of claim 13, wherein the carbon layer has a thickness of 1 nm to 300 nm.

18. The porous silicon-carbon composite of claim 1, which has an average particle diameter ($D_{50}$) of 1 $\mu$m to 20 $\mu$m.

19. The porous silicon-carbon composite of claim 1, which has a specific gravity of 1.8 $g/cm^3$ to 2.6 $g/cm^3$ and a specific surface area (Brunauer-Emmett-Teller method; BET) of 2 $m^2/g$ to 60 $m^2/g$.

20. A process for preparing a porous silicon-carbon composite, which comprises:

a first step of obtaining a silicon composite oxide powder using a silicon-based raw material and a magnesium-based raw material;
a second step of etching the silicon composite oxide powder using an etching solution comprising a fluorine (F) atom-containing compound;
a third step of filtering and drying the composite obtained by the etching to obtain a porous silicon composite; and
a fourth step of forming a carbon layer on the surface of the porous silicon composite by using a chemical thermal decomposition deposition method.

21. The process for preparing a porous silicon-carbon composite of claim 20, which further comprises, after the formation of the carbon layer in the fourth step, crushing or pulverizing and classifying the porous silicon-carbon composite to have an average particle diameter of 1 $\mu$m to 20 $\mu$m.

22. The process for preparing a porous silicon-carbon composite of claim 20, wherein, in the second step, the etching solution further comprises one or more acids selected from the group consisting of organic acids, sulfuric acid, hydrochloric acid, phosphoric acid, nitric acid, and chromic acid.

23. The process for preparing a porous silicon-carbon composite of claim 20, wherein the formation of the carbon layer in the fourth step is carried out by injecting at least one selected from compounds represented by the following Formulae 1 to 3 and carrying out a reaction in a gaseous state at 400°C to 1,200°C:

[Formula 1]      $C_N H_{(2N + 2-A)}[OH]_A$

in Formula 1, N is an integer of 1 to 20, and A is 0 or 1,

[Formula 2]      $C_N H_{(2N-B)}$

in Formula 2, N is an integer of 2 to 6, and B is an integer of 0 to 2, and

[Formula 3]      $C_x H_y O_z$

in Formula 3, x is an integer of 1 to 20, y is an integer of 0 to 25, and z is an integer of 0 to 5.

24. The process for preparing a porous silicon-carbon composite of claim 20, which further comprises forming a carbon layer on the surface of the silicon composite oxide by using a chemical thermal decomposition deposition method in the first step.

25. A negative electrode active material, which comprises the porous silicon-carbon composite of claim 1.

26. The negative electrode active material of claim 25, which further comprises a carbon-based negative electrode material.

27. The negative electrode active material of claim 26, wherein the content of the carbon-based negative electrode material is 30% by weight to 90% by weight based on the total weight of the negative electrode active material.

28. A lithium secondary battery, which comprises the negative electrode active material of claim 25.

[Fig. 1a]

[Fig. 1b]

[Fig. 2a]

[Fig. 2b]

[Fig. 2c]

[Fig. 2d]

[Fig. 3]

[Fig. 4]

(a)

(b)

| Element | Weight % | Atomic % | Net Int. | Error % | Kratio | Z | R | A | F |
|---|---|---|---|---|---|---|---|---|---|
| C K | 12.54 | 22.30 | 701.35 | 11.61 | 0.0296 | 1.1382 | 0.9507 | 0.1657 | 1.0000 |
| O K | 6.04 | 14.75 | 2517.93 | 7.71 | 0.0573 | 1.0766 | 0.9719 | 0.4819 | 1.0000 |
| F K | 8.74 | 9.83 | 2503.46 | 6.67 | 0.0505 | 0.9959 | 0.9809 | 0.5801 | 1.0000 |
| Mg K | 13.76 | 12.09 | 4788.95 | 3.55 | 0.1217 | 0.9782 | 1.0034 | 0.8904 | 1.0152 |
| Si K | 58.92 | 41.03 | 15169.95 | 3.05 | 0.4781 | 0.9564 | 1.0156 | 0.9251 | 1.0021 |

[Fig. 5]

[Fig. 6a]

[Fig. 6b]

[Fig. 6c]

[Fig. 7]

[Fig. 8]

[Fig. 9]

## INTERNATIONAL SEARCH REPORT

| International application No. |
|---|
| **PCT/KR2021/015550** |

| A. | CLASSIFICATION OF SUBJECT MATTER |
|---|---|

**H01M 4/36**(2006.01)i; **H01M 4/38**(2006.01)i; **H01M 4/587**(2010.01)i; **H01M 4/62**(2006.01)i; **H01M 4/48**(2010.01)i; **H01M 10/052**(2010.01)i; **C01B 33/02**(2006.01)i; **C01B 33/10**(2006.01)i

According to International Patent Classification (IPC) or to both national classification and IPC

| B. | FIELDS SEARCHED |
|---|---|

Minimum documentation searched (classification system followed by classification symbols)

H01M 4/36(2006.01); H01M 10/02(2006.01); H01M 10/052(2010.01); H01M 10/0525(2010.01); H01M 4/13(2010.01); H01M 4/485(2010.01); H01M 4/58(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 마그네슘 불화물(magnesium fluoride), 규소 입자(silicon particle), 탄소(carbon), 복합체(complex), 다공성(porous), 식각(etching), 플루오린화 수소(hydrogen fluoride), 규산 마그네슘(magnesium silicate), 음극 활물질(negative active material), 리튬 이차전지(lithium secondary battery)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2019-0065182 A (DAE JOO ELECTRONIC MATERIALS CO., LTD.) 11 June 2019 (2019-06-11)<br>See paragraphs [0013]-[0023], [0025]-[0039], [0041]-[0045], [0047]-[0050], [0052]-[0060], [0073] and [0078]-[0081]. | 1-28 |
| Y | KR 10-2015-0050168 A (LG CHEM, LTD. et al.) 08 May 2015 (2015-05-08)<br>See paragraphs [0013], [0017]-[0078] and [0093]-[0100]; and claims 1, 12 and 27. | 1-28 |
| A | KR 10-2015-0026925 A (LG CHEM, LTD. et al.) 11 March 2015 (2015-03-11)<br>See entire document. | 1-28 |
| A | KR 10-2017-0036417 A (SAMSUNG ELECTRONICS CO., LTD. et al.) 03 April 2017 (2017-04-03)<br>See entire document. | 1-28 |

| ✓ Further documents are listed in the continuation of Box C. | ✓ See patent family annex. |
|---|---|

| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
|---|---|

| Date of the actual completion of the international search | Date of mailing of the international search report |
|---|---|
| **11 February 2022** | **11 February 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

## INTERNATIONAL SEARCH REPORT

| International application No. |
| --- |
| **PCT/KR2021/015550** |

**C.    DOCUMENTS CONSIDERED TO BE RELEVANT**

| Category* | Citation of document, with indication, where appropriate, of the relevant passages | Relevant to claim No. |
| --- | --- | --- |
| A | KR 10-2008-0093243 A (LS MTRON LTD.) 21 October 2008 (2008-10-21)<br>    See entire document. | 1-28 |

Form PCT/ISA/210 (second sheet) (July 2019)

**INTERNATIONAL SEARCH REPORT**
**Information on patent family members**

International application No.

**PCT/KR2021/015550**

| Patent document cited in search report | | | Publication date (day/month/year) | Patent family member(s) | | | Publication date (day/month/year) |
|---|---|---|---|---|---|---|---|
| KR | 10-2019-0065182 | A | 11 June 2019 | CN | 111418095 | A | 14 July 2020 |
| | | | | EP | 3719881 | A1 | 07 October 2020 |
| | | | | JP | 2021-504918 | A | 15 February 2021 |
| | | | | KR | 10-2185490 | B1 | 02 December 2020 |
| | | | | US | 2021-0184204 | A1 | 17 June 2021 |
| | | | | WO | 2019-108050 | A1 | 06 June 2019 |
| KR | 10-2015-0050168 | A | 08 May 2015 | CN | 104756290 | A | 01 July 2015 |
| | | | | CN | 104756290 | B | 31 May 2017 |
| | | | | EP | 3065206 | A1 | 07 September 2016 |
| | | | | JP | 2016-504722 | A | 12 February 2016 |
| | | | | JP | 6138960 | B2 | 31 May 2017 |
| | | | | KR | 10-1656552 | B1 | 09 September 2016 |
| | | | | KR | 10-1813302 | B1 | 28 December 2017 |
| | | | | KR | 10-2015-0050167 | A | 08 May 2015 |
| | | | | TW | 201533964 | A | 01 September 2015 |
| | | | | TW | I565127 | B | 01 January 2017 |
| | | | | US | 10153484 | B2 | 11 December 2018 |
| | | | | US | 2015-0380733 | A1 | 31 December 2015 |
| | | | | WO | 2015-065047 | A1 | 07 May 2015 |
| KR | 10-2015-0026925 | A | 11 March 2015 | CN | 105189352 | A | 23 December 2015 |
| | | | | CN | 105189352 | B | 01 December 2017 |
| | | | | EP | 2873646 | A1 | 20 May 2015 |
| | | | | EP | 2873646 | B1 | 03 April 2019 |
| | | | | JP | 2016-508114 | A | 17 March 2016 |
| | | | | JP | 6037052 | B2 | 30 November 2016 |
| | | | | KR | 10-1636143 | B1 | 04 July 2016 |
| | | | | PL | 2873646 | T3 | 30 August 2019 |
| | | | | TW | 201522220 | A | 16 June 2015 |
| | | | | TW | I583624 | B | 21 May 2017 |
| | | | | US | 2015-0072240 | A1 | 12 March 2015 |
| | | | | US | 9947922 | B2 | 17 April 2018 |
| | | | | WO | 2015-030531 | A1 | 05 March 2015 |
| KR | 10-2017-0036417 | A | 03 April 2017 | CN | 106953069 | A | 14 July 2017 |
| | | | | CN | 106953069 | B | 15 October 2021 |
| | | | | JP | 2017-063026 | A | 30 March 2017 |
| | | | | US | 10050264 | B2 | 14 August 2018 |
| | | | | US | 2017-0092939 | A1 | 30 March 2017 |
| KR | 10-2008-0093243 | A | 21 October 2008 | KR | 10-0868135 | B1 | 10 November 2008 |

Form PCT/ISA/210 (patent family annex) (July 2019)

**REFERENCES CITED IN THE DESCRIPTION**

**Patent documents cited in the description**

- JP 4393610 B
- JP 2016502253 A
- KR 20180106485
- KR 1020180106485